# EUROPÄISCHE PATENTSCHRIFT

(11) **EP 4 464 657 B1**
(45) Veröffentlichungstag und Bekanntmachung des Hinweises auf die Patenterteilung: **10.12.2025**
(21) Anmeldenummer: 24174405.1
(22) Anmeldetag: 06.05.2024
(51) Int. Cl.: B81B 7/00, B81C 1/00, G01P 1/02, G01P 15/125

(54) **HALBLEITERBAUTEIL UMFASSEND EINEN MEMS-SENSOR ODER MEMS-AKTUATOR SOWIE VERFAHREN ZU DESSEN HERSTELLUNG**
SEMICONDUCTOR COMPONENT COMPRISING A MEMS SENSOR OR MEMS ACTUATOR AND METHOD FOR PRODUCING SAME
COMPOSANT SEMI-CONDUCTEUR COMPRENANT UN CAPTEUR MEMS OU UN ACTIONNEUR MEMS ET SON PROCÉDÉ DE FABRICATION

(30) Priorität: 05.05.2023 EP 23171764
(43) Veröffentlichungstag der Anmeldung: 20.11.2024
(73) Patentinhaber: Hahn-Schickard-Gesellschaft für angewandte Forschung e. V., 70569 Stuttgart (DE)
(72) Erfinder: Rockstroh, Jan, 70569 Stuttgart (DE); Trautner, Heiko, 70569 Stuttgart (DE)
(74) Vertreter: Hertin und Partner Rechts- und Patentanwälte PartG mbB

(56) Entgegenhaltungen:
- US-A1- 2007 205 087
- US-A1- 2013 187 245
- ZHANG YANGXI ET AL: "A SOI sandwich differential capacitance accelerometer with low-stress package", THE 9TH IEEE INTERNATIONAL CONFERENCE ON NANO/MICRO ENGINEERED AND MOLECULAR SYSTEMS (NEMS), IEEE, 13 April 2014 (2014-04-13), pages 341 - 345, XP032647744, DOI: 10.1109/NEMS.2014.6908822

## Beschreibung

### BESCHREIBUNG

Die Erfindung betrifft ein Halbleiterbauteil umfassend ein MEMS-Bauteil innerhalb eines Waferstacks umfassend mindestens einen Trägerwafer und einen Deckelwafer. Das MEMS-Bauteil liegt in einer Kavität zwischen dem Trägerwafer und dem Deckelwafer angeordnet vor. Das MEMS-Bauteil ist im Bereich der Kavität mit dem Trägerwafer und dem Deckelwafer durch einen anodischen Bond verbunden. Der Deckelwafer ist mit dem Trägerwafer für eine hermetische Einkapselung des MEMS-Bauteils an lateralen Abschnitten, welche die Kavität umranden, mit Hilfe eines Glasfritbondens verbunden.

Des Weiteren betrifft die Erfindung ein Verfahren zur Herstellung des Halbleiterbauteils. Dazu wird ein Devicewafer zur Bildung des MEMS-Bauteils bereitgestellt. Ferner werden der Trägerwafer und der Deckelwafer bereitgestellt, um das MEMS-Bauteil innerhalb einer Kavität anzuordnen. Das MEMS-Bauteil und/oder der Devicewafer wird im Bereich der Kavität mit dem Trägerwafer und dem Deckelwafer anodisch gebondet. Laterale Abschnitte des Deckelwafers und Trägerwafers, welche die Kavität umranden, werden durch Glasfritbonden miteinander verbunden.

### Hintergrund und Stand der Technik

Im Allgemeinen können verschiedene Bauteile mit Methoden der Halbleitertechnologie bereitgestellt werden. Solche Bauteile bezeichnet man auch als Halbleiterbauteile. Halbleiterbauteile können insbesondere Strukturen aufweisen, welche Größen und Ausmaße im Mikrometerbereich haben. Wird eine mechanische Mikrostruktur mit einer elektrischen Schaltung kombiniert, spricht man auch von einem sogenannten MEMS (engl. microelectromechanical system) oder MEMS-Bauteil.

MEMS-Bauteile können hierbei vorteilhaft Logikelemente und mikromechanische Strukturen auf einem Chip vereinen. Aufgrund ihrer Fähigkeit, mechanische und elektrische Signale zu verarbeiten und/oder zu erzeugen, eignen sie sich für eine Vielzahl von Anwendungen, wie z. B. für Sensoren, Aktoren, Filter und/oder Oszillatoren.

MEMS-Bauteile bilden daher eine wichtige technische Grundlage für Lösungsansätze in der Mikroelektronik. Gegenüber konventionellen Makrosystemen bieten sie vor allem Vorteile in der Kostenersparnis durch einen geringen Verbrauch an Werkstoffen und/oder einer möglichen Parallelfertigung sowie in der Effizienz, welche durch einen geringeren Energie- und Leistungsbedarf ermöglicht wird.

Im Zuge der zunehmenden Integration und Miniaturisierung steigen die Anforderungen an die Aufbau- und Verbindungstechnik. Dabei müssen Fügeprozesse nicht nur die Herstellung einer dauerhaften Verbindung zwischen Komponenten einer Baugruppe gewährleisten, sondern meistens auch weitere Funktionen erfüllen. Dies ist insbesondere bei Sensoren, beispielsweise bei Beschleunigungs- und/oder Drehratensensoren, nichttrivial, welche das Erfordernis einer besonders zuverlässigen Funktionstauglichkeit abdecken sollen.

Inertial- und Drehratensensoren weisen typischerweise bewegliche Abschnitte auf, die eine Masse darstellen. Durch eine Bewegung erfolgt eine Verschiebung der beweglichen Abschnitte, durch welche eine Detektion ermöglicht wird. Für die Detektion wird häufig zumindest eine Elektrode benötigt, welche die Verschiebung eines beweglichen Abschnittes detektieren soll. Zudem kann die mindestens eine Elektrode in einigen Anwendungen für die Einstellung der Position der beweglichen Abschnitte eingesetzt werden.

Bei der Anbringung einer einzelnen Elektrode ist eine Bewegung entlang einer einzigen Achse möglich, die entlang der Elektrode und eines beweglichen Abschnittes geführt ist. Allerdings ist bei der Anbringung einer einzelnen Elektrode die Beibehaltung einer Ruhelage für einen beweglichen Abschnitt nur schwierig sicherzustellen. Zudem ist die Anwendung eines geschlossenen Regelkreises, welcher ein wichtiges Funktionsprinzip darstellt, auf einen Sensor mit nur einer einzelnen Elektrode hinsichtlich der Funktionalität nicht effektiv. Insbesondere ist die geometrische Ausgestaltung der beweglichen Abschnitte eingeschränkt. Beispielsweise werden für die beweglichen Abschnitte häufig mechanische Wippenstrukturen bei der Anbringung einer einzelnen Elektrode eingesetzt, insbesondere auch für eine differentielle Messung. Wippenstrukturen führen jedoch zu einer schlechteren Sensitivität. Zudem kommt nachteilig hinzu, dass Wippenstrukturen asymmetrisch ausgeführt sein müssen, was wiederrum die Ausgestaltung der Elektrodenfläche einschränkt. Parasitäre Effekte sind hierdurch erschwert zu unterdrücken.

Um die Position der beweglichen Abschnitte auf verlässliche Weise auch fixieren bzw. stabilisieren zu können sowie eine Ausgestaltungsfreiheit für die beweglichen Abschnitte zu haben, ist es im Stand der Technik bekannt, ein Elektrodenpaar umfassend zwei Elektroden anzubringen, welche gegenüberliegend voneinander angebracht sind. So kann beispielsweise durch die Anbringung von Elektroden ober- und unterhalb der beweglichen Abschnitte sowohl eine Ruhelage geschaffen als auch eine Bewegung senkrecht entlang einer Ebene ausgeführt werden.

Halbleiterbauteile, welche bewegliche Abschnitte aufweisen, die entlang mehrerer Achsen verschoben werden können, sind in verschiedenen Ausführungsformen im Stand der Technik bekannt. In Aydemir & Akin (2015) wird beispielsweise ein kapazitiver Beschleunigungssensor mit drei Bewegungsachsen offenbart. Mittels des darin offenbarten Beschleunigungssensors kann eine differentielle Messung der Beschleunigung entlang drei zueinander orthogonalen Achsen ausgeführt werden. Dazu liegen ein erster Abschnitt und ein zweiter Abschnitt vor. Am ersten Abschnitt sind bewegliche Abschnitte angebracht, welche senkrecht bzw. vertikal entlang einer z-Achse ausgelenkt werden können. Am zweiten Abschnitt befinden sich bewegliche Abschnitte, welche entlang lateralen Achsen ausgelenkt werden können. Für die Auslenkung entlang der vertikalen Achse liegen zwei Elektroden gegenüberliegend voneinander vor, welche eine unterschiedliche Ausgestaltung haben. So weist die obere Elektrode eine höhere Dicke als die untere Elektrode auf. Ferner liegt die obere Elektrode als eine Schicht eines SOI-Wafers vor, während die untere Elektrode als eine zusätzliche metallische Schicht vorliegt. Die beweglichen Abschnitte werden ebenfalls durch eine Schicht des SOI-Wafers bereitgestellt. Für die Bereitstellung einer Kavität für die beweglichen Abschnitte, die entlang der lateralen Achsen ausgelenkt werden können, wird eine Vertiefung an einem Glasssubstrat angebracht, an der der SOI-Wafer anodisch gebondet wird.

In Zhang et al. (2014) wird ein Beschleunigungssensor offenbart, welcher in einem Sandwichaufbau hergestellt wird. Der Beschleunigungssensor soll sich durch einen mechanisch spannungsarmen Aufbau auszeichnen, indem insbesondere der Einfluss durch thermische Belastungen verringert wird. Im Herstellungsprozess für den Beschleunigungssensor wird ein SOI-Wafer eingesetzt. Dieser wird an einer ersten Seite mit einer Glasplatte anodisch gebondet. Auf der gegenüberliegenden ersten Seite erfolgt ebenfalls ein anodisches Bonden mit einer Glasplatte. Auf den beiden Glasplatten befinden sich abschnittsweise metallische Schichten, sodass auch gegenüberliegende Elektroden bereitgestellt werden und eine vertikale Auslenkung eines beweglichen Abschnittes detektiert werden kann. Im Abschnitt des Beschleunigungssensors, in dem sich die beweglichen Abschnitte befinden, liegt ein Spalt vor, in welchem ein durch Luft eingebrachter Druck vorliegt.

Der Druck, welcher in der Kavität vorliegt, in dem sich die beweglichen Abschnitte befinden, ist eine für den Betrieb des Sensors relevante Größe. Umso niedriger der Druck innerhalb der Kavität ist, desto höher ist die Güte der beweglichen Abschnitte. Der Druck innerhalb der Kavität kann durch direktes Bonden zweier Substrate eingestellt werden. Allerdings ist dann die Einbringung einer elektrischen Kontaktierung, beispielsweise in Form von metallischen Leiterbahnen, innerhalb der Kavität nicht ohne Weiteres möglich. Das ist unter anderem dem Umstand geschuldet, dass elektrische Kontaktierungen, insbesondere metallische Leiterbahnen, bei den Temperaturen, welche beim direkten Bonden aufgebracht werden, nicht auf einfache Weise eingefügt werden können.

Das Einbringen von Leiterbahnen kann jedoch beim anodischen Bonden ausgeführt werden. Allerdings ist beim anodischen Bonden ein gasdichter Verschluss des Druckes innerhalb der Kavität nicht immer gewährleistbar, sodass ein Risiko vorliegt, dass ein Gasaustausch mit der Umgebung stattfinden kann. Hierdurch würde die Funktionstauglichkeit des Sensors benachteiligt werden, insbesondere hinsichtlich eines langlebigen Betriebs und der Präzision der Messerfassung. Als Alternative wäre es möglich, auf ebene Leiterbahnen zu verzichten und stattdessen Durchkontaktierungen einzusetzen, um eine Übertragung von Signalen von oder für die beweglichen Abschnitte innerhalb einer Kavität zu ermöglichen. Die Bereitstellung von Durchkontaktierungen bei gleichzeitiger Wahrung einer Gasdichtheit ist jedoch aufwendig. Mithin gibt es im Stand der Technik ein Bedarf für die Bereitstellung verbesserter Sensoren, die sowohl hinreichend hermetisch verschlossen werden können als auch eine zuverlässige Übertragung von Messsignalen ermöglichen. US 2007/205087 A1 offenbart einen Devicewafer mit einer Schaltwippe eines MEMS-Schalters, welche in einem Hohlraum zwischen einem Basiswafer und einem Glassubstrat angeordnet ist. Im Bereich der Kavität ist der Devicewafer anodisch mit dem Glassubstrat verbunden. Der Basiswafer und das Glassubstrat sind mittels Glasfritbondens für eine hermetische Kapselung der Schaltwippe verbunden.

### Aufgabe der Erfindung

Aufgabe der Erfindung ist es, ein Halbleiterbauteil bzw. Verfahren zu dessen Herstellung bereitzustellen, welches besonders langlebig ist und eine präzise Erfassung von Messwerten ermöglicht.

### Zusammenfassung der Erfindung

Die Aufgabe der Erfindung wird gelöst durch die unabhängigen Ansprüche. Vorteilhafte Ausgestaltungen der Erfindung sind in den abhängigen Ansprüchen offenbart.

In einem ersten Aspekt betrifft die Erfindung ein Halbleiterbauteil umfassend ein MEMS-Bauteil innerhalb eines Waferstacks umfassend mindestens einen Trägerwafer und einen Deckelwafer, wobei das MEMS-Bauteil in einer Kavität zwischen dem Trägerwafer und dem Deckelwafer angeordnet vorliegt, dadurch gekennzeichnet, dass das MEMS-Bauteil im Bereich der Kavität anodisch gebondet mit dem Trägerwafer und dem Deckelwafer verbunden vorliegt und der Deckelwafer mit dem Trägerwafer für eine hermetische Einkapselung des MEMS-Bauteils an lateralen Abschnitten, welche die Kavität umranden, mit Hilfe eines Glasfritbondens verbunden vorliegen.

Das erfindungsgemäße Halbleiterbauteil hat sich in mehreren Aspekten als vorteilhaft erwiesen.

Durch das erfindungsgemäße Halbleiterbauteil wird vorteilhafterweise eine hermetische Verkapselung eines MEMS-Bauteil ermöglicht, welches gleichzeitig stabil elektrisch an einen Träger- sowie Deckelwafer angebunden ist. Zum einen gelingt es dem erfindungsgemäßen Halbleiterbauteil, durch den Einsatz eines anodischen Bondens, insbesondere in Form eines Presskontaktes, zwischen dem MEMS-Bauteil und dem Trägerwafer und dem Deckelwafer Leiterbahnen bei vergleichsweise niedrigen Temperatur anbringen zu können, was beispielsweise beim direkten Bonden nicht möglich wäre. Zum anderen wird durch die Verbindung des Trägerwafers mit dem Deckelwafer mittels des Glasfritbondens ein gasdichter Verschluss gewährleistet. Somit kann vorteilhafterweise weder Gas aus der Kavität in die Umgebung entweichen noch Gas aus der Umgebung in das Halbleiterbauteil hineingelangen. Ein in dem Halbleiterbauteil eingebrachter Druck in Form eines Gases kann mithin langzeitstabil beibehalten werden und das Halbleiterbauteil zeichnet sich durch eine hohe Langlebigkeit aus. Erfindungsgemäß wurde hierbei erkannt, dass eine prozesstechnische Kombination aus einem anodischen Bonden und einem anschließenden Glasfritbonden zu ausgezeichneten Ergebnissen führt.

Die Verbindung durch einen anodische Bond erfolgt vorzugsweise an Kontaktstellen des Trägerwafers und/oder Deckelwafers mit dem MEMS-Bauteil. Das Glasfritbonden, welches beispielsweise durch eine Rahmenschicht am Halbleiterbauteil realisierbar ist, erfolgt vorzugsweise an lateralen Abschnitten des Trägerwafers und des Deckelwafers. Die Rahmenschicht umfasst das für das Glasfritbonden eingesetzte Bondmaterial, insbesondere Glas.

Mit anderen Worten ausgedrückt, werden die Nachteile des anodischen Bondens in Bezug auf eine mangelnde Gasdichtheit behoben, indem das Halbleiterbauteil zwei Verbindungsarten umfasst, nämlich eine Verbindung durch das anodische Bonden und eine Verbindung durch Glasfritbonden. Die Kombination der Verbindungsarten führt darüber hinaus zu weiteren Vorteilen. Neben der vorteilhaften hermetischen Einkapselung des MEMS-Bauteils und damit einer langanhaltenden Betriebsdauer wird auch die Funktionalität als solche verbessert. Das liegt unter anderem daran, dass eine Anbringung von Metallschichten als Elektroden ermöglicht wird, die zur Auslesung und/oder Anregung von Komponenten des MEMS-Bauteils eingesetzt werden, wodurch Messsignale mit erhöhter Sensitivität erfasst werden können. Insbesondere wird vorteilhafterweise ein Anbringen von Metallschichten beidseitig des MEMS-Bauteils ermöglicht, welche als Elektroden fungieren können, sodass eine differentielle Messung oder Ansteuerung ausgeführt werden kann. Besonders vorteilhaft ist hierbei, dass durch eine Kontaktierung mittels eines anodischen Bondens für die Metallschichten bzw. Elektroden ein festgelegter Abstand zum MEMS-Bauteil mit hoher Präzision eingestellt werden kann. Dies erhöht die Anrege- und/oder Auslesemöglichkeiten für das MEMS-Bauteil und verbessert die Sensitivität.

Darüber hinaus kann das Halbleiterbauteil in erheblichem Maße kompakt gehalten werden und ist flexibel in verschiedenen Einsatzbereichen anwendbar. Weiterhin ist das Halbleiterbauteil vorteilhaft mittels im Stand der Technik bewährten Prozessen herstellbar und zeichnet sich somit zudem durch eine hohe Wirtschaftlichkeit aus.

Im Sinne der Erfindung bezeichnet ein Halbleiterbauteil bevorzugt ein Bauelement, welches man für Schaltungen in der Elektrotechnik und/oder der Elektronik insbesondere im Zusammenhang mit Halbleitermaterialien verwendet. Der durchschnittliche Fachmann weiß, dass der Begriff des Halbleiterbauteils weit ausgelegt werden kann. Beispielsweise kann ein Halbleiterbauteil einen integrierten Schaltkreis umfassen, der Transistoren und/oder Dioden aufweist oder selbst ein solches Bauteil sein kann. Vorzugsweise erfolgt die Fertigung der integrierten Schaltkreise auf Wafern, die insbesondere ein Halbleitermaterial umfassen können, jedoch nicht darauf beschränkt sind. Zudem können durch Bearbeitungen des Wafermaterials Bauelemente wie Transistoren, Dioden und/oder Kondensatoren hergestellt werden. Es können auch mehrere Wafer eingesetzt werden, die dann zerteilt werden und mehrere Chips bilden können. Ein Halbleiterbauteil kann auch beispielsweise eine Leiterplatte, mehrere Prozessoren, Halbleiterspeicher, Mikrocontroller, Wandler, Mikrochips etc. umfassen oder selbst sein. Erfindungsgemäß umfasst das Halbleiterbauteil ein MEMS-Bauteil.

Vorzugsweise befindet sich ein MEMS-Bauteil innerhalb einer Kavität eines Wafers oder eines Waferstacks des Halbleiterbauteils. Ein MEMS-Bauteil bezeichnet bevorzugt ein Bauteil oder eine Komponente, welches auf MEMS-Technologie beruht. Die MEMS-Technologie umfasst Techniken, Materialien und Verfahren der Halbleiter- und der Mikrosystemtechnik, um MEMS-Bauteile herzustellen. Durch ein MEMS-Bauteil wird eine kompakte Bauweise (im Mikrometerbereich) bei gleichzeitig hervorragender Funktionalität mit geringen Herstellungskosten erreicht. Ein MEMS-Bauteil kann beispielsweise ein MEMS-Sensor oder auch ein MEMS-Aktuator sein. Insbesondere kann das MEMS-Bauteil bewegliche Abschnitte umfassen.

Das MEMS-Bauteil kann vorzugsweise in Kombination mit einer elektronischen Schaltung vorliegen. Vorzugsweise kann sich die elektronische Schaltung innerhalb oder außerhalb des Halbleiterbauteils befinden. Bevorzugte elektronische Schaltungen umfassen ohne Beschränkung eine integrierte Schaltung (IC), eine anwendungsspezifische integrierte Schaltung (ASIC), eine programmierbare logische Schaltung (PLC), ein Field Programmable Gate Array (FPGA), einen Mikroprozessor, einen Mikrocomputer, eine speicherprogrammierbare Steuerung und/oder eine sonstige elektronische Schaltung, die bevorzugt programmierbar ist.

Es kann auch bevorzugt sein, dass beispielsweise zwei oder mehr Wafer zu einem Waferstack gebildet werden, die eine Kavität umfassen, worin sich das MEMS-Bauteil und/oder die elektronische Schaltung befinden.

Im Sinne der Erfindung umfasst eine Kavität einen Hohlraum innerhalb des Halbleiterbauteils. Bevorzugt wird die Kavität durch eine Strukturierung an einem oder mehreren Wafern gebildet, welcher wiederrum den Waferstack bilden. Vorzugsweise sind an zwei Wafern zur Bildung des Waferstacks Strukturierungen eingebracht, welche jeweils zueinander komplementär ausgestaltet sind. Die Strukturierung am Trägerwafer und/oder Deckelwafer kann bevorzugt als eine Vertiefung vorliegen. Durch die Strukturierung am Trägerwafer und/oder Deckelwafer wird bevorzugt die Kavität gebildet, in die das MEMS-Bauteil eingebracht wird. Vorteilhafterweise kann durch das Vorhandensein einer oder mehrerer Kavitäten ein geeigneter Hohlraum für das MEMS-Bauteil bereitgestellt werden. Hierdurch kann das MEMS-Bauteil innerhalb des Halbleiterbauteils robust und stabil positioniert werden.

Ein Wafer kann beispielsweise eine kreisrunde oder quadratische Scheibe bezeichnen, die eine Dicke im Millimeter oder Submillimeter-Bereich aufweist. Wafer werden typischerweise aus ein- oder polykristallinen (Halbleiter-)Rohlingen, sogenannten Ingots, hergestellt und dienen in der Regel als Substrat für z. B. Beschichtungen oder Bauteile, insbesondere MEMS-Bauteile und/oder elektronische Schaltungen. Die Verwendung des Begriffs Substrat für den Wafer ist im Stand der Technik auch bekannt, wobei das Substrat vorzugsweise das zu behandelnde Material und/oder das zu beschichtende Material bezeichnet. Im Sinne der Erfindung können die Begriffe Wafer und Substrat synonym verwendet werden. Wenn der Begriff "Wafer" verwendet wird, können die Ausführungen sowohl den Trägerwafer als auch den Deckelwafer betreffen.

Ein Waferstack wird vorzugsweise aus mindestens zwei Wafern gebildet, nämlich dem Trägerwafer und Deckelwafer. Ein Waferstack kann bevorzugt auch 3, 4, 5, 6, 7, 8, 9, 10, 15, 20, 50 oder mehr Wafer umfassen. Die Wafer können dabei sowohl horizontal als auch vertikal in zwei oder mehr Schichten miteinander verbunden werden, sodass sich bevorzugt eine dreidimensionale Ausgestaltung bilden kann. Im erfindungsgemäßen Kontext umfasst das Waferstack zumindest den Trägerwafer und den Deckelwafer.

Der Deckelwafer bezeichnet bevorzugt einen Wafer, mit dem das MEMS-Bauteil abgedeckt bzw. eingeschlossen werden kann. Der Deckelwafer kann ein gewöhnlicher Wafer sein. Der Trägerwafer bezeichnet bevorzugt einen Wafer, der als Träger für das MEMS-Bauteil fungiert. Insbesondere kann der Trägerwafer als ein Boden des Halbleiterbauteils aufgefasst werden, während der Deckelwafer als Überdeckung des Halbleiterbauteils erachtet werden kann. Der Trägerwafer und/oder der Deckelwafer können bevorzugt Vertiefungen aufweisen, welche bevorzugt zu einer komplementär ausgestaltet sind, um die Kavität zu bilden, in der sich das MEMS-Bauteil befindet.

Dabei ist das MEMS-Bauteil mit dem Trägerwafer und Deckelwafer durch einen anodischen Bond verbunden. Dies bedeutet insbesondere, dass die Verbindung durch ein anodisches Bonden während eines Herstellungsprozesses des Halbleiterbauteils bereitgestellt wurde. Dabei wird bevorzugt Druck und/oder Temperatur aufgebracht und ein elektrisches Feld angelegt. Der Trägerwafer und das MEMS-bauteil werden aufeinander platziert, um einen ausreichenden Kontakt zwischen den Oberflächen des MEMS-Bauteils und des Trägerwafers und/oder des Deckelwafers zu bilden. Anschließend wird der Stapel erhitzt, um zu garantieren, dass ein Ionenaustausch zwischen den Kontaktstellen erfolgen kann. Zusätzlich wird ein elektrisches Potential angelegt, um den Vorgang zu vereinfachen. Insbesondere resultiert hierdurch an der Bondgrenzfläche eine Oxidschicht, durch die eine stabile Verbindung gesichert ist. Da durch das anodische Bonden insbesondere eine Oxidschicht an der Bondgrenzschicht, insbesondere an den Kontaktstellen, festzustellen lässt, ist somit die anodische Verbindung auch am Halbleiterbauteil selbst strukturell zu erkennen.

Ferner ist der Trägerwafer mit dem Deckelwafer an lateralen Abschnitten mit dem Deckelwafer durch ein Glasfritbonden verbunden. Der Ausdruck "laterale Abschnitte" meint bevorzugt einen Bereich, welcher die Kavität und insbesondere das MEMS-Bauteil umrandet, sodass eine Einkapselung des MEMS-Bauteils innerhalb des Waferstacks ermöglicht wird. Der laterale Abschnitt kann somit als ein geschlossener, vorzugsweise ringförmiger Bereich, erachtet werden, innerhalb dessen das MEMS-Bauteil eingebracht ist. Anders ausgedrückt, bezeichnet ein lateraler Abschnitt bevorzugt eine äußere Umrandung der Kavität, in welcher das MEMS-Bauteil vorzugsweise angeordnet ist.

Die Verbindung zwischen dem Trägerwafer und dem Deckelwafer an dem lateralen Abschnitt liegt durch einen Glasfritbond vor. Beim Glasfritbonden wird vorzugsweise glashaltiges Material, insbesondere in Form von Glaslot und/oder Glasfrit, als eine Zwischenschicht an dem lateralen Abschnitt aufgebracht. Die Zwischenschicht kann auf einem der beiden Wafer, d. h. Trägerwafer oder Deckelwafer, am lateralen Abschnitt positioniert werden, beispielsweise durch ein Druckverfahren. Beim Bondprozess wird vorzugsweise die Zwischenschicht erhitzt bis sie flüssig wird und anschließend werden der Trägerwafer und der Deckelwafer zusammengepresst. Schließlich werden die gebondeten Wafer abgekühlt, wodurch die Zwischenschicht erstarrt. Dadurch entsteht eine mechanisch stabile und hermetische Verbindung, welche insbesondere eine gasdichte Einkapselung des MEMS-Bauteils ermöglicht. Da die Verbindung mit Hilfe eines Glasfritbondens die Zwischenschicht umfassend Glas umfasst, ist diese als Bestandteil des Halbleiterbauteils darin auch als solche zu erkennen, sodass die Verbindung durch ein Glasfritbonden auch am Halbleiterbauteil festzustellen ist.

Es wurde erkannt, dass durch die Kombination einer Verbindung durch einen anodischen Bond und einen Glasfritbond ein gasdichter Verschluss sowie gleichzeitig eine zuverlässige Anbringung von elektrischen Kontaktierungen für das MEMS-Bauteil ermöglicht wird.

In einer weiteren bevorzugten Ausführungsform ist das Halbleiterbauteil dadurch gekennzeichnet, dass jeweils eine dem MEMS-Bauteil zugewandte Oberfläche des Deckelwafers und des Trägerwafers zumindest teilweise eine Metallschicht aufweisen, wobei bevorzugt die Metallschichten als Elektroden einsetzbar sind.

Mithin liegen hierdurch mindestens zwei Metallschichten vor, die an gegenüberliegenden Seiten dem MEMS-Bauteil zugewandt sind. Dabei können vorteilhaft die mindestens zwei Metallschichten auf einen vergleichsweise großflächigen Abschnitt des Trägerwafer und des Deckelwafers angebracht sein. Hierdurch wird insbesondere beim Einsatz der mindestens zwei Metallschichten als Elektroden eine höhere Sensitivität erlangt, insbesondere bei einer differentiellen Anregung und/oder Auslesung des MEMS-Bauteils. Eine höhere Sensitivität erlaubt vorteilhaft wiederrum kleinere Signalamplituden für Anrege- und Auslesesignale. Insbesondere reduziert sich damit das in kapazitiven Sensoren kritische Übersprechen. Zusätzlich wird ein Übersprechen durch den räumlich größeren Abstand der differentiellen Signale reduziert. Mithin wird eine verbesserte Funktionalität des Halbleiterbauteils etabliert.

Besonders bevorzugt liegen die Metallschichten, welche dem MEMS-Bauteil zugewandt sind und sich auf der Oberfläche des Deckelwafers und des Trägerwafers befinden, auf einem dielektrische Material vor. Das dielektrische Material kann bevorzugt als eine Zwischenschicht vorliegen, die zwischen der Metallschicht und dem Trägerwafer oder Deckelwafer angebracht ist. Ebenfalls kann es bevorzugt sein, dass der Trägerwafer und/oder der Deckelwafer selbst ein dielektrisches Material umfasst, beispielsweise Glas, wie z. B. Borosilikatglas, insbesondere BOROFLOAT^{®}. Hierdurch wird es vorteilhafterweise ermöglicht, dass der nachteilige Effekt des Übersprechens weiter verringert wird, da sich keine parallele parasitäre Kapazität ausbildet. Mithin werden kapazitive Störgrößen für den Betrieb des Halbleiterbauteils verringert. Mithin wird sowohl die Sensitivität als auch die Qualität erfassbarer Messsignale, insbesondere vor dem Hintergrund der Verringerung von parasitären Effekten, verbessert. Zudem sorgt die Verbindung durch den anodischen Bond zwischen dem MEMS-Bauteil und dem Trägerwafer sowie dem Deckelwafer für einen stabilen Presskontakt an den Metallschichten, während ein gasdichter Einschluss des MEMS-Bauteils innerhalb der Kavität durch den Glasfritbond gewährleistet wird.

In einer weiteren bevorzugten Ausführungsform ist das Halbleiterbauteil dadurch gekennzeichnet, dass das MEMS-Bauteil bewegliche Abschnitte aufweist, wobei bevorzugt die beweglichen Abschnitte des MEMS-Bauteils horizontal und/oder vertikal auslenkbar sind.

Die beweglichen Abschnitte umfassen bevorzugt Bauelemente und/oder Abschnitte des MEMS-Bauteils. Sie können bevorzugt mechanische und/oder elektrische Informationen verarbeiten und/oder erzeugen. Bevorzugte MEMS-Strukturen sind für Sensoren und/oder Aktoren, aber auch Oszillatoren und/oder Filter geeignet. Die MEMS-Strukturen können bevorzugt charakteristische Abmaße im Mikrometerbereich (1 µm bis 1000 µm) aufweisen. Sie können aber auch bevorzugt kleiner als ein Mikrometer sein oder sich vorzugsweise über mehrere Mikrometer erstrecken. Die beweglichen Abschnitte können bevorzugt translatierbar und/oder rotierbar sein.

Translatierbare bewegliche Abschnitte können insbesondere eine Translationsbewegung durchführen. Hierbei erfahren bevorzugt alle Punkte eines beweglichen Abschnittes dieselbe Verschiebung. Zu einem beliebigen Zeitpunkt sind Geschwindigkeiten und Beschleunigungen aller Punkte des beweglichen Abschnittes im Wesentlichen identisch. Insbesondere bewegen sich die Punkte eines beweglichen Abschnittes bei einer Translation auf parallelen Trajektorien. Translatierbare bewegliche Abschnitte sind beispielsweise geeignet für Beschleunigungssensoren.

Rotierbare bewegliche Abschnitte können insbesondere eine Rotationsbewegung durchführen. Vorzugsweise kann sich hierbei ein beweglicher Abschnitt um eine Rotationsachse bewegen. Die Rotationsachse kann, muss aber nicht, durch einen Massenmittelpunkt gehen. Insbesondere bleiben alle Punkte der Rotationsachse an ihrem Ort, während alle anderen Punkte sich in festem Abstand von der Rotationsachse auf einem senkrecht zur Achse liegenden Kreis oder Ellipse um denselben Winkel um sie herumbewegen. Rotierbare bewegliche Abschnitte eignen sich beispielsweise für Drehratensensoren bzw. Gyroskope.

Die beweglichen Abschnitte können bevorzugt auch schwingfähig sein. Schwingfähige bewegliche Abschnitte können eine Schwingung durchführen. Als Schwingungen werden bevorzugt zeitliche und/oder örtliche Schwankungen eines Punktes eines beweglichen Abschnittes bezeichnet. Unter Schwankung ist dabei die Abweichung von einem Mittelwert zu verstehen. Schwingungen können mit einem Freiheitsgrad oder mit einer Vielzahl von Freiheitsgraden erfolgen. Insbesondere umfasst eine Schwingung eine mögliche Verformung einer oder mehrerer MEMS-Strukturen, die vorzugsweise mechanische Schwingungen betreffen.

Die beweglichen Abschnitte können bevorzugt in Form einer Kammfingerstruktur vorliegen. Eine Kammfingerstruktur bezeichnet bevorzugt eine Anordnung, bei der die MEMS-Struktur ineinandergreifende Kammfinger umfassen. Diese Kammfinger können bevorzugt einzelne Elektroden bilden, welche ein System von Kondensatoren darstellen. Kondensatoren und damit Kammelektroden besitzen bevorzugt die Eigenschaft, dass sie eine nichtlineare Kennlinie aufweisen, die durch die Übertragungsfunktion zwischen elektrischer Spannung und elektrostatischer Kraft bzw. Auslenkung beschrieben wird. Eine derartige nichtlineare Kennlinie kann vorzugsweise gewünscht sein, um bei dem Grad der Auslenkung eine große Sensitivität für kleine Auslenkungen bzw. eine kleine Sensitivität für große Auslenkungen zu erhalten.

Vorzugsweise sind die beweglichen Abschnitte des MEMS-Bauteils vertikal und/oder horizontal auslenkbar. Eine horizontale Auslenkbarkeit umfasst bevorzugt eine Auslenkung entlang einer Ebene, innerhalb derer sich das MEMS-Bauteil befindet. Eine vertikale Auslenkbarkeit umfasst vorzugsweise eine Bewegung, die senkrecht zur Ebene ausgeführt werden kann, innerhalb derer sich das MEMS-Bauteil befindet.

Vorteilhafterweise kann das MEMS-Bauteil somit sowohl als sogenannter in-plane Sensor als auch als sogenannter out-of-plane Sensor betrieben werden, sodass in der Anwendung vielfältige Einsatzmöglichkeiten durch das Halbleiterbauteil gegeben sind. Ein in-plane Sensor bezeichnet bevorzugt ein MEMS-Bauteil umfassend bewegliche Abschnitten, welche entlang einer Ebene ausgelenkt werden können. Ein out-of-plane Sensor bezeichnet bevorzugt ein MEMS-Bauteil umfassend bewegliche Abschnitte, welche senkrecht zur Ebene, entlang der sich das MEMS-Bauteil befindet, ausgelenkt werden können. Vorteilhafterweise kann somit das MEMS-Bauteil als in-plane Sensor und/oder als out-of-plane Sensor betrieben werden.

In einer weiteren bevorzugten Ausführungsform ist das Halbleiterbauteil dadurch gekennzeichnet, dass bei einer vertikalen Auslenkung von beweglichen Abschnitten des MEMS-Bauteils an einer Metallschicht des Deckelwafers ein erstes Messsignal und an der Metallschicht der Trägerwafers ein zweites Messsignal sowie über das erste Messsignal und das zweite Messsignal ein differentielles Messsignal auslesbar ist.

Ein differentielles Messignal meint bevorzugt eine Messsignal, welches aus einer Kombination eines ersten und zweiten Messsignals resultiert und vorzugsweise durch eine Differenz des ersten und zweiten Messsignales gebildet wird. Vorteilhafterweise ist ein differentielles Messsignal gegenüber Störgrößen deutlich weniger anfällig als ein einzelnes Messsignal. Typischerweise ist jedes einzelne Signal des differentiellen Messsignales gleichermaßen anfällig gegenüber einer Störgröße und kann, der Störung entsprechend, einen verfälschten Absolutwert annehmen. Die Differenz der gestörten Signale entspricht dem zu übermittelnden Signal und wird dabei selbst nicht beeinflusst, da beide Signale in genau demselben Maß durch die Störgröße beeinflusst werden. Vorteilhafterweise wird durch die Bereitstellung eines differentiellen Messignals mithin eine hohe Zuverlässigkeit und hochaufgelöste Messung ermöglicht, unabhängig von etwaigen Störgrößen.

In weiteren bevorzugten Ausführungsformen wird nicht nur eine Differenz des ersten und zweiten Messsignales gebildet, sondern auch weitere Rechenoperationen bevorzugt ausgeführt, wie beispielsweise eine Addition, eine Multiplikation und/oder eine Division. Insbesondere können das erste und zweite Messsignal damit für die Bildung eines Kombinationssignals als Messsignal verwandt werden. Ein Kombinationssignal umfasst ein Messsignal, welches durch eine oder mehrere der genannten Rechenoperationen umfassend Subtraktion, Addition, Multiplikation und/oder Division gebildet wird.

Ferner kann es bevorzugt sein, zusätzlich zu einem ersten und zweiten Messsignal weitere Messsignale, beispielsweise ein drittes, viertes, fünftes usw. Messsignal aufzunehmen und ein Kombinationssignal, bevorzugt auch ein Differenzsignal, auszulesen.

In einer weiteren bevorzugten Ausführungsform ist das Halbleiterbauteil dadurch gekennzeichnet, dass die Metallschichten mit Leiterbahnen und/oder Umkontaktierungen zur Übertragung von Messsignalen verbunden vorliegen, wobei bevorzugt die Leiterbahnen mit beweglichen Abschnitten des MEMS-Bauteils verbunden sind.

Leiterbahnen (auch Leitbahn oder Leitungsbahn genannt) bezeichnen bevorzugt elektrisch leitende Verbindungen mit zweidimensionalem Verlauf, das heißt entlang einer Ebene, der sogenannten Leiterbahn- oder Metallisierungsebene. Sie dienen bevorzugt zur Strom- bzw. Spannungsversorgung und/oder zur Signalübertragung. Die Verbindung zwischen einzelnen Leiterbahnebenen erfolgt vorzugsweise mithilfe von Umkontaktierungen.

Eine Umkontaktierung umfasst bevorzugt eine elektrische Verbindung, durch die eine Übertragung von Messsignalen über verschiedene Ebenen ermöglicht wird. Vorzugsweise kann die Umkontaktierung als eine im Wesentlichen vertikale elektrische Verbindung vorliegen. Bevorzugt kann die Umkontaktierung eine Durchkontaktierung umfassen. Insbesondere kann durch die Umkontaktierung eine Übertragung eines Messsignals vom Trägerwafer in Richtung des Deckelwafers und/oder vom Deckelwafer in Richtung des Trägerwafers erfolgen.

Im Hinblick auf die die Nutzung eines differentiellen Messsignals, bevorzugt eines Kombinationssignals, hat sich die Anbringung einer Umkontaktierung als besonders vorteilhaft erwiesen. Durch die bevorzugte Umkontaktierung kann eine Übertragung von zwei oder mehr Messsignalen für die Bildung eines Differenzsignals, bevorzugt eines Kombinationssignals, durch eine einzige elektrische Verbindung erfolgen. Komplexe elektrische Verbindungen werden hierdurch vorteilhaft vermieden.

Durch die bevorzugte Verbindung von Leiterbahnen mit einem oder mehreren beweglichen Abschnitten des MEMS-Bauteils wird eine zuverlässige Übertragung von Signalen gewährleistet, um die Auslenkung und/oder Bewegung auszulesen und/oder anzuregen. Insbesondere kann durch den Einsatz von Umkontaktierungen eine Übertragung zwischen verschiedenen Ebenen das Halbleiterbauteils ermöglicht werden, ohne Einschränkungen hinsichtlich eines potentiellen Signalverlustes hinnehmen zu müssen.

In einer weiteren bevorzugten Ausführungsform ist das Halbleiterbauteil dadurch gekennzeichnet, dass eine dem MEMS-Bauteil zugewandte Seite des Trägerwafers und/oder des Deckelwafers einen Vorsprung aufweist, sodass ein Abstand zwischen dem MEMS-Bauteil und dem Trägerwafer und/oder Deckelwafer regulierbar ist.

Ein Vorsprung bezeichnet einen Abschnitt des Trägerwafers und/oder Deckelwafers, welcher eine Erhöhung im Verlauf einer Oberfläche darstellt. Ein Vorsprung kann bevorzugt eine Höhe aufweisen von 5-15 µm, vorzugsweise von 5-10 µm. Vorteilhafterweise wird durch den Vorsprung ein im Wesentlichen paralleler Abschnitt am Trägerwafer und/oder am Deckelwafer geschaffen. Hierdurch kann die Positionierung des MEMS-Bauteils, insbesondere von beweglichen Abschnitten, präzise und flexibel eingestellt werden kann. Insbesondere kann vorteilhaft ein Abstand zwischen dem MEMS-Bauteil zum Trägerwafer und/oder Deckelwafer festgelegt werden. Mithin ist es auch möglich, bevorzugt den Abstand zwischen einer Metallschicht als Elektrode sowie dem MEMS-Bauteil zu optimieren. Hierdurch kann vorteilhafterweise eine präzise Einstellung zur Elektrode festgelegt werden, was insbesondere für kapazitiven Messungen von Vorteil ist. Ferner kann zudem die Fähigkeit der Auslenkbarkeit von beweglichen Abschnitten des MEMS-Bauteils angepasst werden. Hierdurch kann eine weitere Anpassung der Auflösung und/oder Sensitivität der Messung erzielt werden.

In weiteren bevorzugten Ausführungsformen sind am Trägerwafer und/oder Deckelwafer ein oder mehrere Stopper angebracht. Ein Stopper bezeichnet bevorzugt ebenfalls eine Erhöhung am entsprechenden Wafer. Vorzugsweise weist ein Stopper eine niedrigere Höhe als ein bevorzugter Vorsprung auf. In bevorzugten Ausführungsformen weist ein Stopper eine Höhe von 1-5 µm, bevorzugt zwischen 2-3 µm auf. Vorteilhaft können durch ein oder mehreren Stopper ein unerwünschtes Verkleben des MEMS-Bauteils, insbesondere von beweglichen Abschnitten, verhindert werden.

In einer weiteren bevorzugten Ausführungsform ist das Halbleiterbauteil dadurch gekennzeichnet, dass innerhalb der Kavität ein Druck vorliegt zwischen 0 - 10 bar, bevorzugt zwischen 1,5 - 5 bar oder zwischen 10⁻⁶ - 0,5 bar.

Vorteilhafterweise kann ein vielseitiges Spektrum an Druckwerten innerhalb der Kavität des Halbleiterbauteils eingeschlossen werden. Dies überträgt sich vorteilhaft auch auf die möglichen Einsatzgebiete, sodass vielfältige Anwendungen für das Halbleiterbauteil in Frage kommen. Insbesondere kann innerhalb des Halbleiterbauteils bei einigen Anwendungsgebieten ein Unterdruck eingeschlossen werden, d. h. ein Druckwert, welcher geringer ist als ein Umgebungsdruck, in dem sich das Halbleiterbauteil befindet. Ein Unterdruck ist insbesondere bei einem Drehratensensor bzw. Gyroskop vorteilhaft. Vorzugsweise kann ein Unterdruck beispielsweise einen Druck zwischen 10⁻⁶ - 0,5 bar bezeichnen. Ebenfalls ist es vorteilhaft möglich, einen Überdruck innerhalb des Halbleiterbauteils einzuschließen. Ein Überdruck bezeichnet einen Druckwert, der größer ist als der Umgebungsdruck des Halbleiterbauteils. Ein eingeschlossener Überdruck ist insbesondere im Falle von Beschleunigungssensoren vorteilhaft. Vorzugsweise kann ein Überdruck beispielsweise einen Druck zwischen 1,5 - 5 bar bezeichnen.

In einer weiteren bevorzugten Ausführungsform ist das Halbleiterbauteil dadurch gekennzeichnet, dass das MEMS-Bauteil ausgewählt ist aus einer Gruppe umfassend einen Beschleunigungssensor, einen Drehratensensor, einen Lorentzkraft-Magnetometer, einen Neigungssensor, einen Durchflusssensor und/oder einen Drucksensor.

Ein Beschleunigungssensor dient der Messung von Beschleunigungen. Der Fachmann erkennt, dass hierfür verschiedene Messprinzipien eingesetzt werden können. Ein bekanntes Messprinzip, welches für den erfindungsgemäßen Kontext auch bevorzugt ist, ist das der kapazitiven Messung. Dazu umfasst das MEMS-Bauteil bewegliche Abschnitte, die sich bevorzugt gegenüber einer Metallschicht, welche auf dem Trägerwafer und/oder Deckelwafer befindet und als Elektrode verwendet werden, bewegen können. Bei einer Beschleunigung kommt es zu einer Veränderung eines Abstandes zwischen den beweglichen Abschnitten und den Elektroden. Die Abstandsvariation beeinflusst die Kapazität, welche zwischen den beweglichen Abschnitten und den Elektroden vorliegt, sodass durch die Veränderung der Kapazität auf die Beschleunigung geschlossen werden kann.

Ein Drehratensensor (auch als Gyroskop bekannt) ermöglicht die Messung von Drehbewegungen. Insbesondere kann mithilfe eines Drehratensensors die Winkelgeschwindigkeit entlang einer oder mehreren Rotationsachsen erfasst werden. Dazu liegen am MEMS-Bauteile bewegliche Abschnitte vor, die verschoben werden, wenn das Halbleiterbauteil eine Drehung erfährt und es damit auch zu einer Veränderung der Winkelgeschwindigkeit kommt. Auch für einen Drehratensensor sind verschiedene Messprinzipien bekannt, die eingesetzt werden können. Eine bevorzugte Messmethode ist ein kapazitives Messprinzip unter Nutzung der Corioliskraft, welche bei Drehbewegungen auftritt. Die Corioliskraft wirkt senkrecht zur Bewegungsrichtung von beweglichen Abschnitten des MEMS-Bauteils und ist proportional zur durch die Rotation wirkende Winkelgeschwindigkeit. Durch die Verschiebung kommt es wiederrum zu einer Kapazitätsänderung, was zur Ermittlung einer Drehrate berücksichtigt werden kann.

Mithilfe eines Lorentzkraft-Magnetometers kann ein Magnetfeld gemessen werden. Dabei beruht das Messprinzip insbesondere auf der mechanischen Bewegung eines beweglichen Abschnittes des MEMS-Bauteils durch die Lorentzkraft, die auf einen stromdurchflossenen Leiter im Magnetfeld wirkt. Der entsprechende bewegliche Abschnitt kann elektronisch oder optisch ausgelesen werden. Vorzugsweise wird der bewegliche Abschnitt zu ihrer Resonanz getrieben, um ein maximales Ausgangssignal zu erhalten. Für die elektronische Erfassung können piezoresistive und elektrostatische Transduktionsverfahren verwendet werden. Bei der optischen Erkennung kann auch die Verschiebungsmessung mit einer Laser- oder LED-Quelle verwendet werden.

Ein Neigungssensor dient insbesondere der Messung einer Position und damit eines Winkels in Bezug zur Schwerkraft. Auch dies kann vorzugsweise durch die Anwendung eines kapazitiven Messprinzipes erfolgen, ohne auf diese Ausführungsform beschränkt zu sein. Bei einer Neigung des Halbleiterbauteils, beispielsweise bei horizontaler Lage, kann die Kapazität zwischen einem beweglichen Abschnitt und einer Metallschicht des Deckelwafers und/oder Trägerwafers als Elektrode nach einer Abstandsänderung gemessen werden, um daraufhin auf den Neigungswinkel zu schließen. Der Neigungswinkel kann bevorzugt auch durch einen Beschleunigungssensor und Drehratensensor bestimmt werden, welche vom MEMS-Bauteil umfasst sind.

Ein Durchflusssensor dient der Messung einer Durchflussrate eines Gases oder einer Flüssigkeit. Auch hierfür können verschiedene Messprinzipien angewendet werden, beispielsweise durch ein thermisches oder ein auf einer Corioliskraft basierendes. Insbesondere Corioliskraft basierende Messprinzipien sind besonders gut geeignet im erfindungsgemäßen Kontext, da die Corioliskraft direkt proportional zum Massenstrom und unabhängig von Temperatur, Druck, Strömungsprofil und/oder Fluideigenschaften ist. Ein Kanal für den Durchfluss des Gases oder der Flüssigkeit würde bevorzugt durch einen Abschnitt im MEMS-Bauteil gebildet werden, insbesondere durch einen beweglichen Abschnitt.

Mithilfe eines Drucksensors kann eine wirkende Last bzw. ein auftretender Druck gemessen werden. Typischerweise wirkt der Druck derart, dass dies eine Formänderung einer Komponente des MEMS-Bauteils herbeiführt, beispielsweise einer Membran. Die Formänderung wiederum ermöglicht die Auslesung eines elektrischen Signals, beispielsweise eines Spannungssignals beim Einsatz eines piezoelektrischen Materials.

Mithin eignet sich das Halbleiterbauteil für die Einsatzfähigkeit einer Vielzahl von Sensoren als MEMS-Bauteil, welche sich in einem breiten Anwendungsspektrum applizieren lassen sowie über eine solide und langanhaltende Funktionsweise verfügen.

In einem weiteres Aspekt betrifft die Erfindung ein System umfassend ein Halbleiterbauteil nach einem erfindungsgemäßen Aspekt oder nach einer bevorzugten Ausführungsform im Sinne des obig Beschriebenen dadurch gekennzeichnet, dass das Halbleiterbauteil jeweils eine dem MEMS-Bauteil zugewandte Oberfläche des Deckelwafers und des Trägerwafers zumindest teilweise eine Metallschicht aufweisen und mit einer Recheneinheit datenverbunden ist, wobei bevorzugt die Recheneinheit dazu konfiguriert ist, mindestens zwei Messsignale ausgehend von den Metallschichten aufzunehmen und ein differentielles Messsignal zu bilden.

Der durchschnittliche Fachmann erkennt, dass technische Merkmale, Definitionen und Vorteile von Ausführungsformen, welche für das obig beschriebene Halbleiterbauteil offenbart wurden, gleichermaßen auf das System zutreffen, und umgekehrt.

Insbesondere kann somit die Differenz eines ersten Messsignales und eines zweiten Messsignales durch die Recheneinheit bestimmt werden, welche durch die beiden Metallschichten, welche am Trägerwafer und Deckelwafer bevorzugt angebracht sind, erfasst werden können. Das kann insbesondere dann relevant sein, wenn das MEMS-Bauteil bewegliche Abschnitte aufweist, welche vertikal auslenkbar sind. Bei einer vertikalen Auslenkung in Richtung des Deckelwafers ist der Abstand gegenüber der Metallschicht am Trägerwafer geringer als der Abstand zur Metallschicht am Trägerwafer. Umgekehrt ist bei einer vertikalen Auslenkung in Richtung des Trägerwafers der Abstand zur Metallschicht am Trägerwafer geringer als der Abstand zur Metallschicht, die sich am Deckelwafer befindet. Mithin werden durch die unterschiedlichen Abstände unterschiedliche Messsignale durch die Metallschichten aufgenommen, welche für die Bildung des differentiellen Messsignals genutzt werden können. Die unterschiedlichen Signale können bevorzugt auch ein anderweitiges Messignal, insbesondere auch ein allgemeines Kombinationssignal bilden. Die Bildung des differentiellen Messsignales, oder eines allgemeinen Kombinationssignals, erfolgt bevorzugt mithilfe der Recheneinheit. Die Recheneinheit kann bevorzugt innerhalb des Halbleiterbauteils angebracht sein. Ebenso kann es bevorzugt sein, dass die Recheneinheit außerhalb des Halbleiterbauteils vorliegt und eine Datenverbindung zum MEMS-Bauteil aufweist.

Eine Recheneinheit bezeichnet im Sinne der Erfindung bevorzugt eine Datenverarbeitungseinheit, die in der Lage ist, eine Verarbeitung von mittels dem MEMS-Bauteil aufgenommene Daten vorzunehmen. Die Recheneinheit kann bevorzugt eine elektronische Schaltung umfassen, welche sich innerhalb oder außerhalb des Halbleiterbauteils befindet. Bevorzugte elektronische Schaltungen umfassen ohne Beschränkung eine integrierte Schaltung (IC), eine anwendungsspezifische integrierte Schaltung (ASIC), eine programmierbare logische Schaltung (PLC), ein Field Programmable Gate Array (FPGA), einen Mikroprozessor, einen Mikrocomputer, eine speicherprogrammierbare Steuerung und/oder eine sonstige elektronische Schaltung, die bevorzugt programmierbar ist. Die Recheneinheit kann bevorzugt zudem eine Speichereinheit umfassen. Eine Speichereinheit erlaubt die Sicherung und/oder Zwischenspeicherung von Daten. Nicht beschränkende Beispiele von Speichern, vorzugsweise Halbleiterspeicher, sind flüchtige Speicher, (RAM)-Speicher oder nicht-flüchtige Speicher, wie ROM-Speicher, EPROM-Speicher, EEPROM-Speicher oder Flash-Speicher und/oder andere Speichertechnologien.

Die Recheneinheit kann insbesondere selbst ein Prozessor oder eine Prozesseinheit sein oder von mehreren Prozessoren gebildet werden. Die Recheneinheit ist bevorzugt dazu bestimmt, mindestens zwei Messsignale ausgehend von den Metallschichten aufzunehmen und ein differentielles Messsignal zu bilden, oder bevorzugt ein allgemeines Kombinationssignal. Zu diesem Zweck ist es bevorzugt, dass auf der Recheneinheit eine Software oder Firmware installiert vorliegt, welche dazu eingerichtet ist bzw. Befehle umfasst, um mindestens zwei Messsignale ausgehend von den Metallschichten aufzunehmen und ein differentielles Messsignal zu bilden, bevorzugt ein Kombinationssignal. Die Begriffe "Software", "Programm" und "Computerprogramm" können synonym verwendet werden.

In einer weiteren bevorzugten Ausführungsform ist das System dadurch gekennzeichnet, dass die Recheneinheit dazu konfiguriert ist, durch einen geschlossenen Regelkreis eine Position von beweglichen Abschnitten des MEMS-Bauteils einzustellen.

Dem durchschnittlichen Fachmann ist bekannt, dass durch einen geschlossenen Regelkreis im Allgemeinen eine vorgegebene Größe (Regelgröße) auf einen gewünschten Wert (Sollwert) gebracht werden soll, indem ein Istwert gemessen und nachgeregelt wird.

Im erfindungsgemäßen Kontext ist die Regelgröße vorzugsweise mindestens ein Abstand eines beweglichen Abschnittes zu mindestens einer Metallschicht, die sich am Trägerwafer und/oder Deckelwafer des Halbleiterbauteils befindet. Die Regelgröße kann bevorzugt auch einen Abstand betreffen, der zwischen mehreren beweglichen Abschnitten des MEMS-Bauteils vorliegt. Insbesondere bezieht sich die Regelgröße auf eine Ausgangslage eines beweglichen Abschnittes relativ zu einem Abschnitt des Halbleiterbauteils. Die entsprechende Ausgangslage korrespondiert vorzugsweise mit einem Ausgangsmesssignal. Eine Veränderung des Abstandes entspricht einem Messvorgang, beispielsweise durch eine kapazitive Messung. Der Istwert entspricht dementsprechend dem geänderten Abstand, wobei bevorzugt die Änderung als eine Änderung der Ausgangsposition zu einer Metallschicht als Elektrode festgestellt werden kann. Innerhalb der Recheneinheit, insbesondere der Speichereinheit, liegen vorzugsweise Werte und/oder Wertebereiche vor, die einen gewünschten Abstand bzw. eine Ausgangsposition für einen beweglichen Abschnitt des MEMS-Bauteils beschreiben. Diese Werte und/oder Wertebereiche des Abstandes, auf die der bewegliche Abschnitt des MEMS-Bauteils gebracht werden soll, entsprechen den vorgegebenen Zielwerten.

Zum Erreichen eines Zielwertes bzw. Sollwertes wird bevorzugt eine Größe, insbesondere eine elektrische Größe, wie z. B. eine elektrische Spannung, an einer Elektrode bzw. Metallschicht angelegt, um einen beweglichen Abschnitt des MEMS-Bauteils nach einer Variation zurück in die Ausgangslage und damit für eine Erfassung eines Ausgangsmesssignals zu positionieren.

Vorzugsweise kann die Einstellung bzw. Rückführung der Position eines beweglichen Abschnittes des MEMS-Bauteils durch die Recheneinheit vorgenommen werden. Hierzu liegt auf der Recheneinheit bevorzugt eine Software installiert vor, um die notwendige Anpassung für die Rückpositionierung zu ermitteln.

In einem weiteren Aspekt betrifft die Erfindung ein Verfahren zur Herstellung eines Halbleiterbauteils umfassend ein MEMS-Bauteil, welches innerhalb eines Waferstacks in einer Kavität zwischen einem Trägerwafer und einem Deckelwafer angeordnet vorliegt, umfassend die folgende Schritte:
a) Bereitstellen eines Devicewafers zur Bildung des MEMS-Bauteils,
b) Bereitstellen eines Trägerwafers und eines Deckelwafers zur Bildung einer Kavität, in welchem das MEMS-Bauteil angeordnet wird,
c) Anodisches Bonden des MEMS-Bauteils und/oder Devicewafers mit dem Trägerwafer und dem Deckelwafer im Bereich der Kavität,
d) Glasfritbonden von lateralen Abschnitten des Deckelwafers und des Trägerwafers, welche die Kavität umranden, für eine hermetische Einkapselung des MEMS-Bauteils.

Der durchschnittliche Fachmann erkennt, dass technische Merkmale, Definitionen und Vorteile von Ausführungsformen, welche für das obig beschriebene Halbleiterbauteil und/oder System offenbart wurden, gleichermaßen auf das Verfahren zutreffen, und umgekehrt.

Der Devicewafer bezeichnet einen Wafer, in dem das MEMS-Bauteil gebildet wird. Dazu können bevorzugt Strukturen eingebracht werden, welche insbesondere als bewegliche Abschnitte des MEMS-Bauteils fungieren können. Der Devicewafer kann vorzugsweise einen gewöhnlichen Wafer umfassen. Auch andere Wafervarianten, wie z. B. ein SOI-Wafer können als Devicewafer bevorzugt sein. Ein SOl-Wafer umfasst eine Trägerschicht, eine Isolationsschicht und eine Deviceschicht, wobei die Isolationsschicht zwischen der Trägerschicht und der Deviceschicht angeordnet ist. Ein SOl-Wafer ist insbesondere deshalb vorteilhaft, da durch ihre strukturelle Ausgestaltung eine besonders effektive Bildung des MEMS-Bauteils erfolgen kann.

Der Trägerwafer und Deckelwafer fungieren insbesondere als eine Ummantelung für das MEMS-Bauteil. Ferner weisen sie bevorzugt eine Strukturierung auf, insbesondere in Form von Vertiefungen, welche vorzugsweise komplementär zueinander ausgestaltet sind, um die Kavität zu bilden. Durch eine oder mehrere Kavitäten wird für das MEMS-Bauteil ein geeigneter Platz bereitgestellt, sodass das MEMS-Bauteil innerhalb des Halbleiterbauteils robust und stabil positioniert werden kann. Hierdurch wird zudem vorteilhaft ein ausreichender räumlicher Abschnitt für das MEMS-Bauteil geschaffen, sodass ein hinreichend großer Freiraum für Bewegungsoptionen von beweglichen Abschnitten des MEMS-Bauteils vorliegen.

Der Trägerwafer und/oder der Deckelwafer wird mit dem MEMS-Bauteil und/oder Devicewafer anodisch gebondet. Dabei kann es bevorzugt sein, dass der Devicewafer zunächst mit einem oder beiden Wafern anodisch gebondet und daraufhin das MEMS-Bauteil in dem Devicewafer gebildet wird. Auch eine umgekehrte Reihenfolge kann bevorzugt sein, d. h., dass zunächst das MEMS-Bauteil in dem Devicewafer gebildet wird und daraufhin das anodische Bonden mit dem Trägerwafer und/oder Deckelwafer ausgeführt wird.

Es kann bevorzugt sein, dass das MEMS-Bauteil und/oder der Devicewafer mit dem Trägerwafer und daraufhin mit dem Deckelwafer anodisch gebondet wird. Auch eine umgekehrte Reihenfolge kann bevorzugt sein, d. h., dass ein anodisches Bonden mit dem Deckelwafer und daraufhin mit dem Trägerwafer ausgeführt wird.

Laterale Abschnitte des Deckelwafers und des Trägerwafers, welche die Kavität umranden, in der sich das MEMS-Bauteil befindet, werden durch Glasfritbonden miteinander gebondet. Durch das Glasfritbonden wird vorteilhaft eine hermetische Einkapselung des MEMS-Bauteils ermöglicht. Hierbei ist es bevorzugt, dass zunächst der Devicewafer und/oder das MEMS-Bauteil mit dem Trägerwafer und/oder Deckelwafer anodisch gebondet wird und daraufhin laterale Abschnitte des Trägerwafers und des Deckelwafers durch Glasfritbonden miteinander verbunden werden.

Vorteilhafterweise wird es hierdurch ermöglicht, eine elektrische Kontaktierung, beispielsweise durch Leiterbahnen, durch einen Presskontakt mit dem MEMS-Bauteil hermetisch zu verkapseln. Des Weiteren wird durch die Verbindung des Trägerwafers mit dem Deckelwafer mittels des Glasfritbondens ein gasdichter Verschluss ermöglicht. Somit kann vorteilhafterweise weder Gas aus der Kavität in die Umgebung entweichen noch Gas aus der Umgebung in das Halbleiterbauteil hineingelangen. Demzufolge kann ein in dem Halbleiterbauteil eingebrachter Druck in Form eines Gases langzeitstabil beibehalten werden.

Vorteilhafterweise zeichnet sich das Verfahren durch eine erhebliche Prozesseffizienz aus, wobei ein hermetisches Verkapseln des MEMS-Bauteils bei gleichzeitiger elektrischer Kontaktierung ermöglicht wird.

In einer weiteren bevorzugten Ausführungsform ist das Verfahren dadurch gekennzeichnet, dass beim anodischen Bonden eine Temperatur vorliegt von ca. 300°C - 500°C und eine Spannung von ca. 50 V - 1 000 V zwischen Kontaktstellen des Trägerwafers und/oder des Deckelwafers und dem MEMS-Bauteil angelegt wird, sodass das MEMS-Bauteil mit dem Trägerwafer und/oder dem Deckelwafer verbunden wird.

Wie obig beschrieben, werden beim anodischen Bonden vorzugsweise das MEMS-Bauteil und der Trägerwafer und/oder der Deckelwafer aufeinander platziert und mit Druck beaufschlagt, um einen Stapel zu bilden und einen ausreichenden Kontakt zwischen den Oberflächen herzustellen. Der Stapel wird auf eine Temperatur innerhalb des genannten Temperaturbereiches erhitzt. Zudem wird eine elektrische Spannung innerhalb des genannten Bereiches angelegt. Die Erhöhung der Temperatur dient insbesondere dazu, die Mobilität der Ionen zu erhöhen, während durch die angelegte Spannung ein lonenübergang zwischen dem MEMS-Bauteil und dem Trägerwafer und/oder Deckelwafer stattfinden kann.

Beim anodischen Bonden bildet sich vorzugsweise eine Oxidschicht als Zwischenschicht zwischen dem MEMS-Bauteil und dem Trägerwafer sowie zwischen dem MEMS-Bauteil und dem Deckelwafer an den Kontaktstellen, welche auch am Halbleiterbauteil festzustellen ist. Hierdurch kann eine mechanisch stabile Verbindung ermöglicht werden. Zudem können vorteilhafterweise Metallschichten und/oder Leiterbahnen beim anodischen Bonden bei den darin erwähnten Prozessparametern eingesetzt werden. Insbesondere kann eine derartige Einbringung von Metallschichten erfolgen, dass ein definierter Abschnitt gegenüber dem MEMS-Bauteil erzielt wird, sodass auch für das herzustellende Halbleiterbauteil als solches eine vorteilhafte Betriebstauglichkeit ermöglicht wird.

In einer weiteren bevorzugten Ausführungsform ist das Verfahren dadurch gekennzeichnet, dass beim Glasfritbonden ein Bondmaterial auf dem Deckelwafer und/oder Trägerwafer angebracht wird und eine Temperatur vorliegt von ca. 400°C - 600°C, wobei eine Verbindung zwischen dem Deckelwafer und dem Trägerwafer über das Bondmaterial durch eine Ausübung eines mechanischen Drucks erfolgt.

Vorzugsweise wird beim Glasfritbonden ein Material umfassend Glas als eine Zwischenschicht an dem lateralen Abschnitt aufgebracht. Die Zwischenschicht kann auf einem der beiden Wafer, d. h. Trägerwafer oder Deckelwafer, am lateralen Abschnitt positioniert werden, beispielsweise durch ein Druckverfahren. Beim Bondprozess wird die die Zwischenschicht erhitzt, bis sie flüssig wird und anschließend werden der Trägerwafer und der Deckelwafer durch einen mechanischen Druck aneinander geführt, bevorzugt indem sie zusammengepresst werden. Schließlich werden die gebondeten Wafer abgekühlt, wodurch die Zwischenschicht erstarrt. Dadurch entsteht eine mechanisch stabile und hermetische Verbindung, welche insbesondere eine gasdichte Einkapselung des MEMS-Bauteils innerhalb der Kavität ermöglicht. Da die Verbindung mit Hilfe eines Glasfritbondens die Zwischenschicht umfassend Glas umfasst, ist diese als Bestandteil des Halbleiterbauteils darin auch als solche zu erkennen, sodass die Verbindung durch ein Glasfritbonden auch am Halbleiterbauteil festgestellt werden kann. Die Zwischenschicht umfassend Glas kann auch eine weitere Materialkomponenten aufweisen, wodurch die Glasübergangstemperatur verringert wird, beispielsweise durch Blei. Hierdurch kann vorteilhaft die Temperatur zur Verflüssigung des Bondmaterials verringert werden.

Vorteilhafterweise resultiert durch die Kombination des Einsatzes eines anodischen Bondens und eines Glasfritbondens ein effektives Halbleiterbauteil. Während das anodische Bonden die Einbringung von Metallschichten und/oder Leiterbahnen ermöglicht, wird durch das Glasfritbonden ein gasdichter Einschluss des MEMS-Bauteils gebildet. Hierdurch wird vorteilhaft ein langlebiges Halbleiterbauteil geschaffen, da sowohl das MEMS-Bauteil als auch die elektrischen Kontaktierungen zum MEMS-Bauteil, insbesondere die Leiterbahnen, nicht einem evtl. eindringbaren Gas ausgesetzt werden.

Besonders vorteilhaft ist der Umstand, dass die für das anodische Bonden und Glasfritbonden einzusetzenden Prozessparameter die Ausgestaltung, die durch einen dieser Bondverfahren für das Halbleiterbauteil erlangt wird, nicht negativ beeinflussen. So wird beispielsweise durch die eingesetzte Temperatur für das Glasfritbonden die Nutzbarkeit von beispielsweise Leiterbahnen weiterhin gewährleistet, die andernfalls bei einer zu hohen Temperaturen negativ beeinflusst werden würden

In einer weiteren bevorzugten Ausführungsform ist das Verfahren dadurch gekennzeichnet, dass das Bondmaterial ein Material umfasst, ausgewählt aus einer Gruppe umfassend Glaslote und/oder Glasfriten.

Glaslot umfasst bevorzugt ein Glas, welches eine niedrige Erweichungstemperatur aufweist, bspw. von ca. oder auch weniger als ca. 400°C. Glasfrit umfasst bevorzugt oberflächlich geschmolzenes Glaspulver, dessen Glaskörner bevorzugt zumindest teilweise zusammenbacken bzw. -sintern. Sowohl Glaslot als auch Glasfrit sind geeignete Materialien, um ein Glasfritbonden auszuführen.

In einer weiteren bevorzugten Ausführungsform ist das Verfahren dadurch gekennzeichnet, dass jeweils eine dem MEMS-Bauteil zugewandte Oberfläche des Deckelwafers und des Trägerwafers zumindest teilweise mit einer Metallschicht beschichtet wird, wobei bevorzugt Metallschichten als Elektroden fungieren.

Zur Beschichtung der Metallschicht kann ein Beschichtungsverfahren ausgeführt werden, ausgewählt aus einer Gruppe umfassend Sprühbeschichtung, Nebelbeschichtung und/oder Dampfbeschichtung. Die genannten Beschichtungsverfahren sind dem Fachmann bekannt und können einfach in das erfindungsgemäße Verfahren oder einer bevorzugten Ausführungsform des Verfahrens integriert werden, um die Beschichtung einer Metallschicht vorzunehmen. Die Metallschichten können insbesondere als Elektroden für das Halbleiterbauteil fungieren. Die Metallschichten können bevorzugt auch für den Einsatz, insbesondere die Kontaktierung, weiterer Komponenten des Halbleiterbauteils in Frage kommen, beispielsweise für Leiterbahnen und/oder Umkontaktierungen.

In einer weiteren bevorzugten Ausführungsform ist das Verfahren dadurch gekennzeichnet, dass der Devicewafer zur Bildung des MEMS-Bauteil und/oder von beweglichen Abschnitten des MEMS-Bauteils mit Polier- und/oder Ätzverfahren bearbeitet wird, bevorzugt nasschemische Ätzverfahren und/oder Trockenätzverfahren, besonders bevorzugt physikalische und/oder chemische Trockenätzverfahren, besonders bevorzugt durch reaktives Ionenätzen und/oder reaktives lonentiefätzen (Bosch-Prozess) oder Kombinationen der vorgenannten Ätzverfahren eingesetzt werden.

Die vorgenannten Ätzverfahren sind dem Fachmann bekannt. In Abhängigkeit der gewünschten Ausgestaltung der Struktur des Devicewafers können vorteilhafte Verfahren gewählt werden, um eine effiziente Durchführung zu gewährleisten. Insbesondere kann eine derart gelungene Strukturierung für bewegliche Abschnitte des MEMS-Bauteils erzielt werden, wodurch sich ein in funktioneller Hinsicht vorteilhaftes Halbleiterbauteil prozessieren lässt.

In einer weiteren bevorzugten Ausführungsform ist das Verfahren dadurch gekennzeichnet, dass der Trägerwafer und/oder der Deckelwafer ein Glas, bevorzugt Borsilikatglas, und/oder ein Devicewafer monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid und/oder Indiumphosphid umfasst.

Die bevorzugten Materialien für den Trägerwafer und/oder Deckelwafer sind vorteilhafterweise in der Halbleiter- und/oder Mikrosystemtechnik besonders einfach und kostengünstig zu bearbeiten und eignen sich ebenfalls gut für eine Massenherstellung. Ebenso sind diese Materialien für ein Dotieren und/oder ein Beschichten besonders geeignet, um in bestimmten Bereichen die gewünschten elektrischen, thermischen und/oder optischen Eigenschaften zu erzielen. Die vorgenannten Materialien bieten vielfältige Vorteile aufgrund der Verwendbarkeit standardisierter Verfahrenstechniken, welche für die Integration von weiteren Komponenten, wie z. B. elektrische Kontaktierungen und/oder elektronischen Schaltungen, ebenfalls besonders gut geeignet sind.

Die erfindungsgemäßen Aspekte sollen im Folgenden anhand von Figuren beispielhaft näher beschrieben werden, ohne auf diese Figuren und Erläuterungen beschränkt zu sein.

### FIGUREN

### Kurzbeschreibung der Figuren

- **Fig. 1**: Schematische Darstellung einer bevorzugten Ausführungsform des erfindungsgemäßen Halbleiterbauteils.
- **Fig. 2**: Schematische Darstellung von bevorzugten Verfahrensschritten zur Herstellung einer bevorzugten Ausführungsform des erfindungsgemäßen Halbleiterbauteils.

### Detaillierte Beschreibung der Figuren

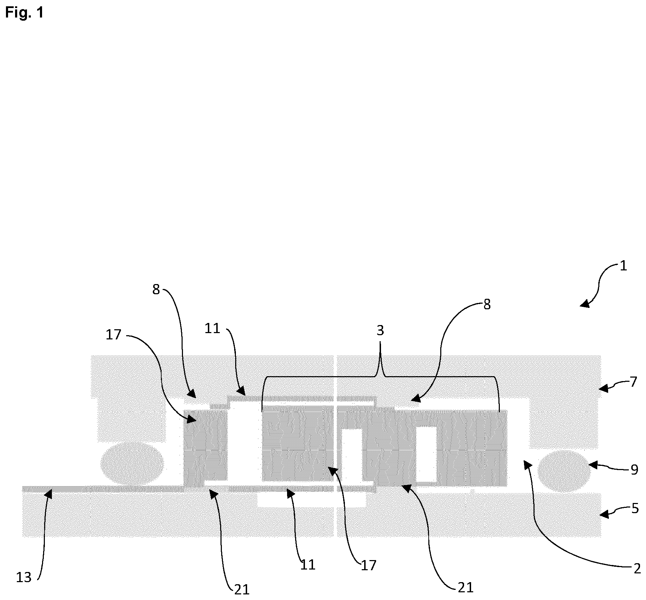

Fig. 1 zeigt schematisch eine bevorzugte Ausführungsform eines erfindungsgemäßen Halbleiterbauteils **1.** Das Halbleiterbauteil **1** umfasst ein MEMS-Bauteil **3** innerhalb eines Waferstacks umfassend einen Trägerwafer **5** und einen Deckelwafer **7.** Das MEMS-Bauteil **3** liegt in einer Kavität **2** zwischen dem Trägerwafer **5** und dem Deckelwafer **7** angeordnet vor. Das MEMS-Bauteil **3** ist im Bereich der Kavität **2** durch anodisches Bonden mit dem Trägerwafer **5** und dem Deckelwafer **7** verbunden. Der Deckelwafer **7** ist mit dem Trägerwafer **5** für eine hermetische Einkapselung des MEMS-Bauteils **3** an lateralen Abschnitten, welche die Kavität **2** umranden, mit Hilfe eines Glasfritbondens verbunden.

Durch das erfindungsgemäße Halbleiterbauteil **1** wird vorteilhafterweise eine hermetische Verkapselung des MEMS-Bauteils **3** ermöglicht, gleichzeitig elektrisch stabil an den Trägerwafer **5** sowie den Deckelwafer **7** angebunden ist. Zum einen gelingt es dem Halbleiterbauteil **1** durch den Einsatz eines anodischen Bondens, insbesondere in Form eines Presskontaktes, zwischen dem MEMS-Bauteil **3** und dem Trägerwafer **5** und dem Deckelwafer **7** Leiterbahnen **13** bei vergleichsweise niedrigen Temperatur anbringen zu können, was beispielsweise beim direkten Bonden nicht möglich wäre. Zum anderen wird durch die Verbindung des Trägerwafers **5** mit dem Deckelwafer **7** mittels des Glasfritbondens ein gasdichter Verschluss gewährleistet. Somit kann vorteilhafterweise weder Gas aus der Kavität **2** in die Umgebung entweichen noch Gas aus der Umgebung in das Halbleiterbauteil **1** hineingelangen. Ein in dem Halbleiterbauteil **1** eingebrachter Druck in Form eines Gases kann mithin langzeitstabil beibehalten werden und das Halbleiterbauteil **1** zeichnet sich durch eine hohe Langlebigkeit aus. Erfindungsgemäß wurde hierbei erkannt, dass eine prozesstechnische Kombination aus einem anodischen Bonden und einem anschließenden Glasfritbonden zu ausgezeichneten Ergebnissen führt.

Die Verbindung durch einen anodische Bond erfolgt an Kontaktstellen **21** des Trägerwafers **5** und/oder Deckelwafers **7** mit dem MEMS-Bauteil **3.** Das Glasfritbonden, welches durch eine Rahmenschicht **9** am Halbleiterbauteil **1** realisierbar ist, erfolgt an lateralen Abschnitten des Trägerwafers **5** und des Deckelwafers **7.** Die Rahmenschicht **9** umfasst das für das Glasfritbonden eingesetzte Bondmaterial, bevorzugt Glas.

Mit anderen Worten ausgedrückt, werden die Nachteile des anodischen Bondens in Bezug auf eine mangelnde Gasdichtheit behoben, indem das Halbleiterbauteil **1** zwei Verbindungsarten umfasst, nämlich eine Verbindung durch das anodische Bonden und eine Verbindung durch Glasfritbonden. Die Kombination der Verbindungsarten führt darüber hinaus zu weiteren Vorteilen. Neben der vorteilhaften hermetischen Einkapselung des MEMS-Bauteils **3** und damit einer langanhaltenden Betriebsdauer wird auch die Funktionalität als solche verbessert. Das liegt unter anderem daran, dass eine Anbringung von Metallschichten **11** als Elektroden ermöglicht wird, die zur Auslesung und/oder Anregung von Komponenten des MEMS-Bauteils **3** eingesetzt werden, wodurch Messsignale mit erhöhter Sensitivität erfasst werden können. Insbesondere wird vorteilhafterweise ein Anbringen von Metallschichten **11** beidseitig des MEMS-Bauteils **3** ermöglicht, welche als Elektroden fungieren können, sodass eine differentielle Messung ausgeführt werden kann. Besonders vorteilhaft ist hierbei, dass durch eine Kontaktierung mittels eines anodischen Bondens für die Metallschichten **11** bzw. Elektroden ein festgelegter Abstand zum MEMS-Bauteil **3** mit hoher Präzision eingestellt werden kann. Dies erhöht die Anrege- und/oder Auslesemöglichkeiten für das MEMS-Bauteil **3** und verbesserte die Sensitivität.

Darüber hinaus kann das Halbleiterbauteil **1** in erheblichem Maße kompakt gehalten werden und ist flexibel in verschiedenen Einsatzbereichen anwendbar. Weiterhin ist das Halbleiterbauteil **1** vorteilhaft mittels im Stand der Technik bewährten Prozessen herstellbar und zeichnet sich somit zudem durch eine hohe Wirtschaftlichkeit aus.

Das Halbleiterbauteil **1** weist jeweils auf der dem MEMS-Bauteil **3** zugewandten Oberfläche des Deckelwafers **7** und des Trägerwafers **5** zumindest teilweise eine Metallschicht **11** auf. Mithin liegen hierdurch mindestens zwei Metallschichten **11** vor, die an gegenüberliegenden Seiten dem MEMS-Bauteil **3** zugewandt sind. Dabei können die zwei Metallschichten **11** auf einen vergleichsweise großflächigen Abschnitt des Trägerwafers **5** und des Deckelwafers **7** angebracht sein. Hierdurch wird insbesondere beim Einsatz der mindestens zwei Metallschichten **11** als Elektroden eine höhere Sensitivität erlangt, insbesondere bei einer differentiellen Anregung und/oder Auslesung des MEMS-Bauteils **3.** Eine höhere Sensitivität erlaubt vorteilhaft wiederrum kleinere Signalamplituden für Anrege- und Auslesesignale. Insbesondere reduziert sich damit das in kapazitiven Sensoren kritische Übersprechen. Zusätzlich wird das Übersprechen durch den räumlich größeren Abstand der differentiellen Signale reduziert. Mithin wird eine verbesserte Funktionalität des Halbleiterbauteils **1** etabliert. Zudem kann auch das Ausbilden einer parasitären Kapazität verringert oder verhindert werden.

Die Metallschichten **11** sind mit Leiterbahnen **13** und/oder Umkontaktierungen **15** zur Übertragung von Messsignalen verbunden. Dabei dienen die Leiterbahnen **13** der Strom- bzw. Spannungsversorgung und/oder zur Signalübertragung. Die Verbindung zwischen einzelnen Leiterbahnebenen **13** erfolgt mithilfe von Umkontaktierungen **15.**

Durch eine Verbindung von Leiterbahnen **13** mit einem oder mehreren beweglichen Abschnitten des MEMS-Bauteils wird eine zuverlässige Übertragung von Signalen gewährleistet, um die Auslenkung und/oder Bewegung auszulesen und/oder anzuregen. Insbesondere kann durch den Einsatz von Umkontaktierungen **15** eine Übertragung zwischen verschiedenen Ebenen das Halbleiterbauteils **1** ermöglicht werden, ohne Einschränkungen hinsichtlich eines potentiellen Signalverlustes hinnehmen zu müssen.

Darüber hinaus weist eine dem MEMS-Bauteil **3** zugewandte Seite des Trägerwafers **5** und/oder des Deckelwafers **7** einen Vorsprung **8** auf, sodass ein Abstand zwischen dem MEMS-Bauteil **3** und dem Trägerwafer **5** und/oder Deckelwafer **7** regulierbar ist. Ein Vorsprung **8** bezeichnet einen Abschnitt des Trägerwafers **5** und/oder Deckelwafers **7,** welcher eine Erhöhung im Verlauf einer Oberfläche darstellt. Vorteilhafterweise wird durch den Vorsprung **8** ein im Wesentlichen paralleler Abschnitt am Trägerwafer **5** und/oder am Deckelwafer **7** geschaffen. Hierdurch kann die Positionierung des MEMS-Bauteils **3,** insbesondere von beweglichen Abschnitten **17,** präzise und flexibel eingestellt werden kann. Insbesondere kann vorteilhaft ein Abstand zwischen dem MEMS-Bauteil **3** zum Trägerwafer **5** und/oder Deckelwafer **7** festgelegt werden. Mithin ist es auch möglich, den Abstand zwischen einer Metallschicht **11** als Elektrode sowie dem MEMS-Bauteil **3** zu optimieren. Hierdurch kann vorteilhafterweise eine präzise Einstellung zur Elektrode **11** festgelegt werden, was insbesondere für kapazitiven Messungen von Vorteil ist. Ferner kann zudem die Fähigkeit der Auslenkbarkeit von beweglichen Abschnitten **17** des MEMS-Bauteils **3** angepasst werden. Hierdurch kann eine weitere Anpassung der Auflösung und/oder Sensitivität der Messung erzielt werden.

Des Weiteren können am Trägerwafer **5** und/oder Deckelwafer **7** Stopper **10** angebracht sein. Ein Stopper **10** bezeichnet ebenfalls eine Erhöhung am entsprechenden Wafer. Ein Stopper **10** weist eine niedrigere Höhe als den Vorsprung **8** auf. Vorteilhaft können durch ein oder mehrere Stopper **10** ein unerwünschtes Verkleben des MEMS-Bauteils **3,** insbesondere von beweglichen Abschnitten **17,** verhindert werden.

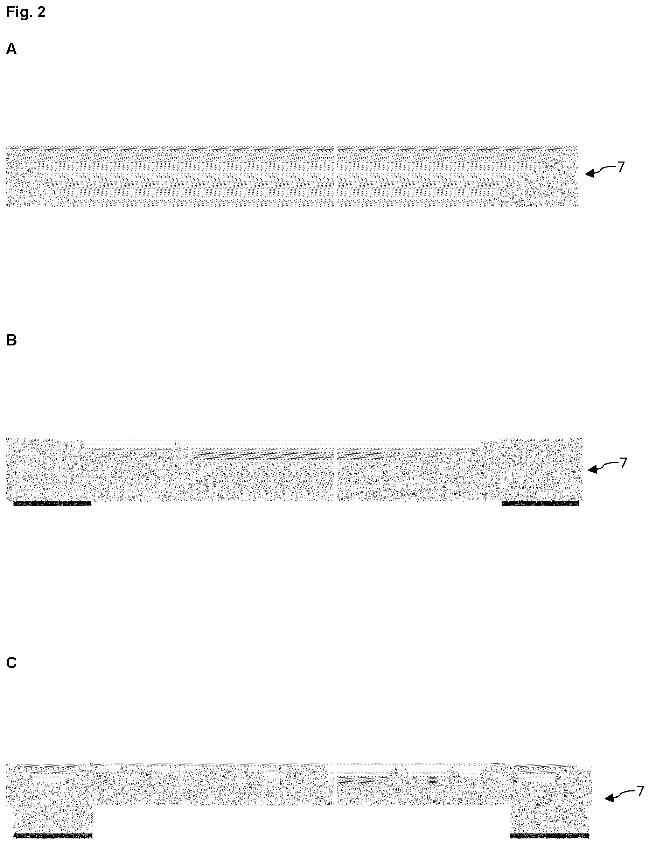

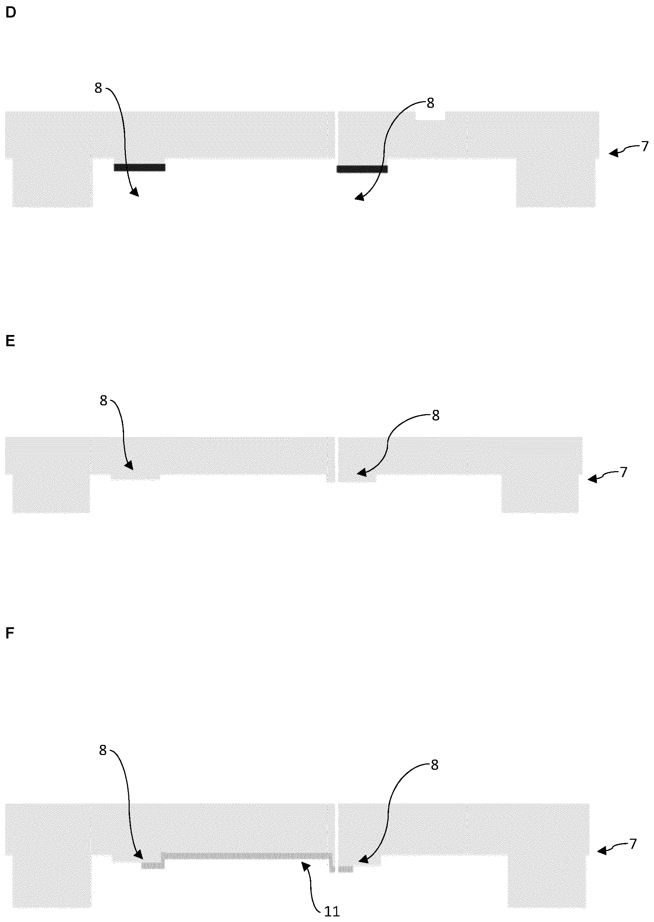

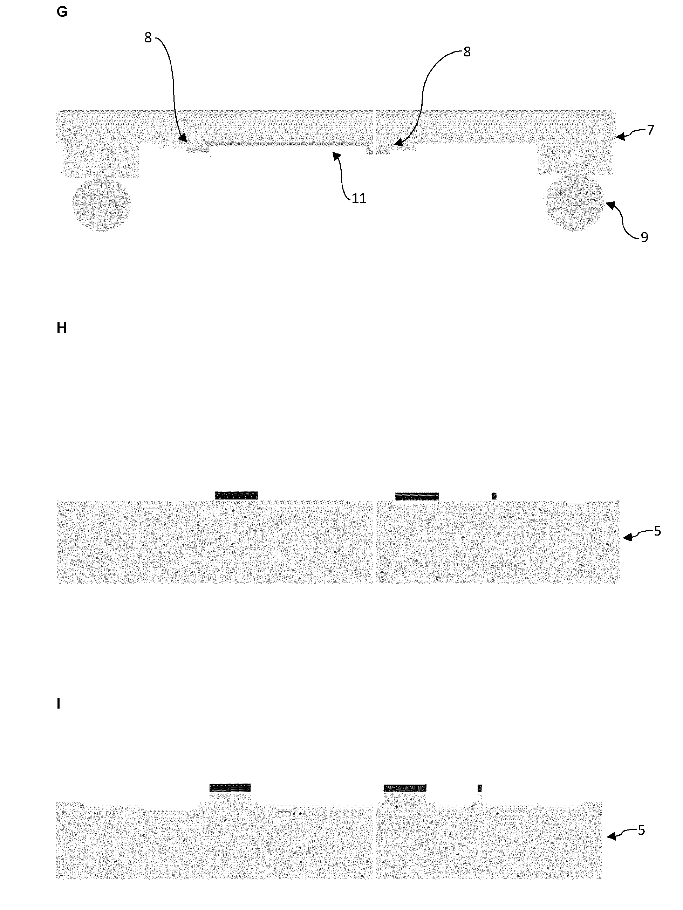

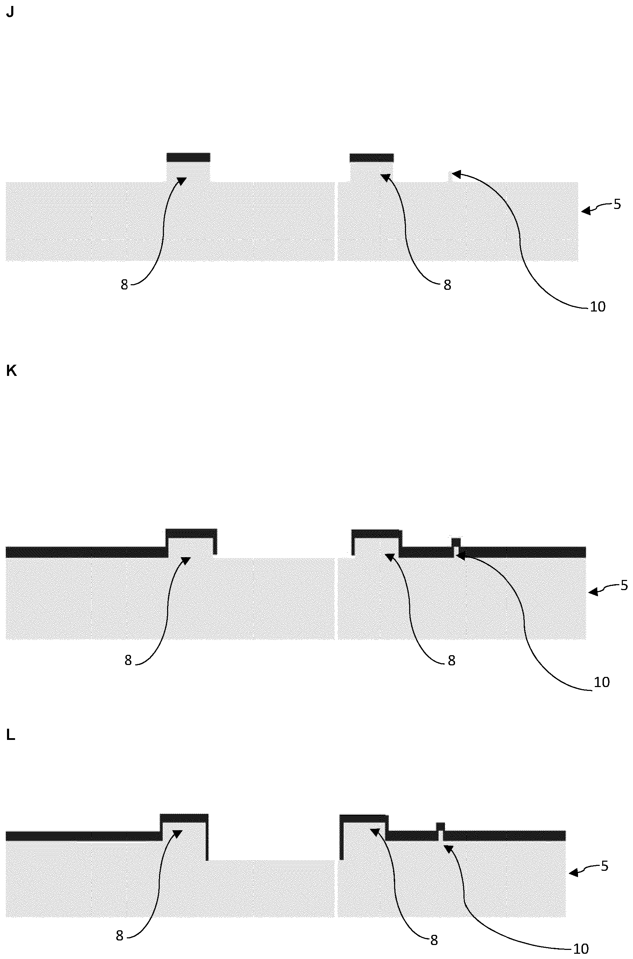

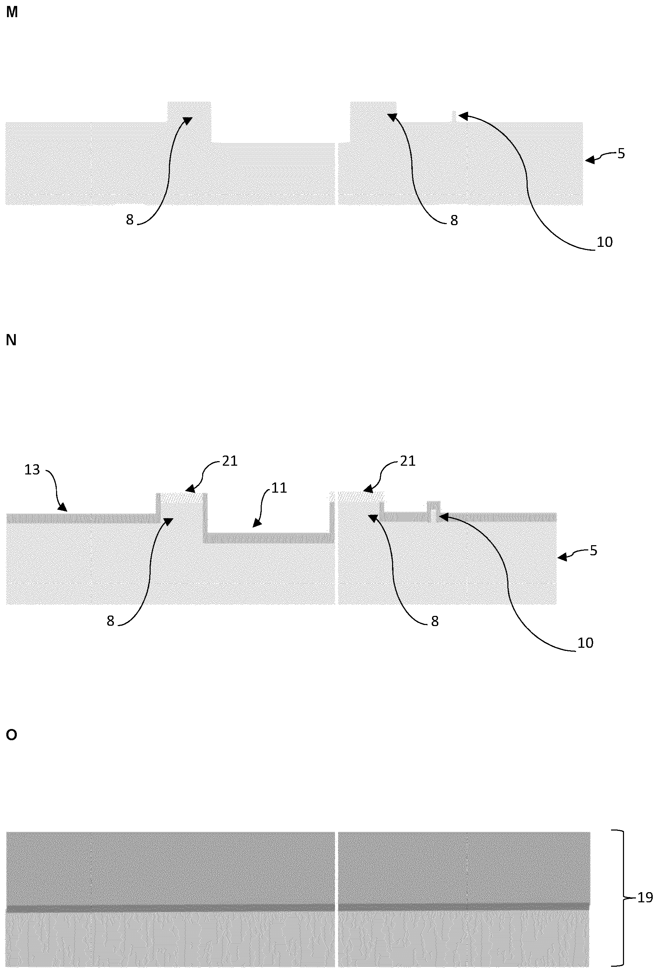

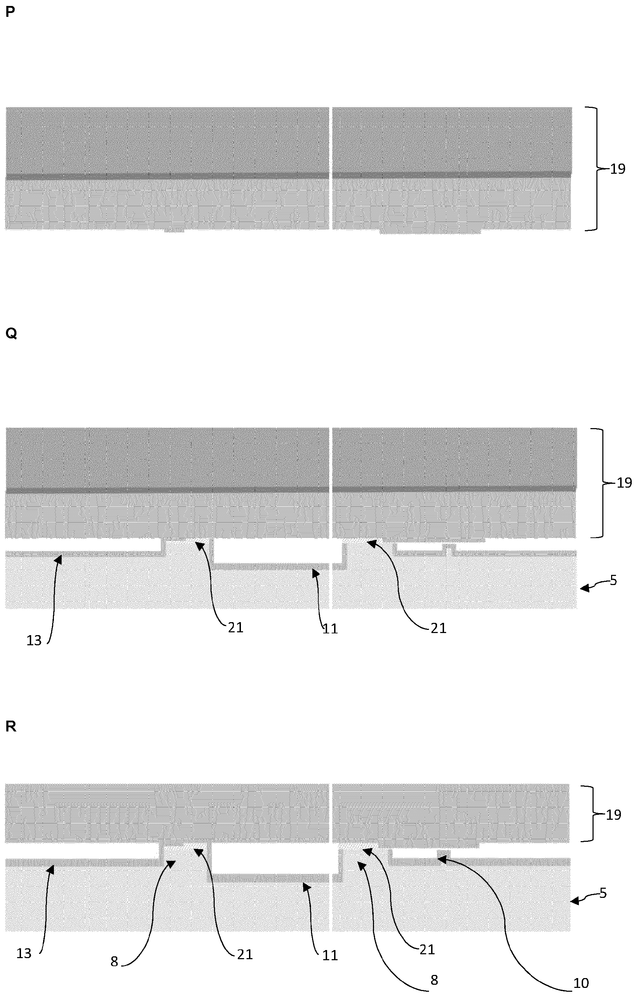

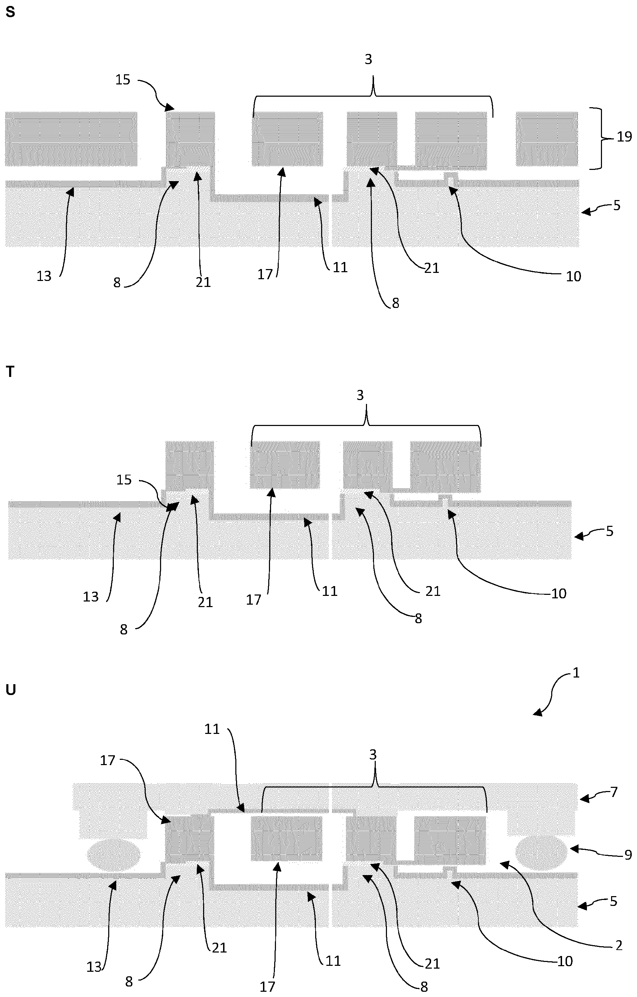

In der Fig. 2 werden bevorzugte Schritte für ein Verfahren schematisch dargestellt, um ein Halbleiterbauteil **1** herzustellen.

Fig. 2A zeigt das Bereitstellen eines Deckelwafers **7.** In Fig. 2B wird die Beschichtung einer Opferschicht auf dem Deckelwafer **7** dargestellt. Hierdurch liegt ein Abschnitt vor, der geätzt werden kann, um die Ausgestaltung des Deckelwafers **7** vorzunehmen. Dies kann insbesondere durch ein Ätzverfahren erfolgen, um einen Bereich der Kavität für das MEMS-Bauteil innerhalb des Waferstacks zu bilden, was in Fig. 2C gezeigt wird. In Fig. 2D-E wird die Bereitstellung von Vorsprüngen **8** durch einen Einsatz und eine Entfernung einer Opferschicht gezeigt, durch die ein gewünschter Abstand zwischen dem Deckelwafer **7** und dem MEMS-Bauteil eingestellt werden kann. In Fig. 2F wird eine Oberfläche des Deckelwafers **7,** welche dem MEMS-Bauteil zugewandt sein soll, zumindest teilweise mit einer Metallschicht **11** beschichtet. Die Metallschicht **11** kann insbesondere als eine Elektrode für das MEMS-Bauteil fungieren. Fig. 2G veranschaulicht die Beschichtung einer Rahmenschicht **9** auf den Deckelwafer **7.** Dies erfolgt auf einem lateralen Abschnitt des Deckelwafers **7,** wobei die Rahmenschicht **9** ein Bondmaterial für ein Glasfritbonden mit dem Trägerwafer umfasst.

Fig. 2H zeigt schematisch einen Trägerwafer **5.** Der Trägerwafer **5** ist mit einer Opferschicht beschichtet, sodass die freigelassenen Bereiche für eine Strukturierung des Trägerwafers **5** geätzt werden können, was in den Fig. 2I-J dargestellt wird. Hierdurch können Vorsprünge **8** am Trägerwafer **5** und ein Stopper **10** gebildet werden. Durch die Vorsprünge **8** kann ein Raumbereich gebildet werden, um einen festgelegten Abstand zum MEMS-Bauteil einstellen zu können. Durch den Stopper **10** kann vorteilhaft ein unerwünschtes Verkleben verhindert werden. In Fig. 2K wird die Beschichtung einer weiteren Opferschicht dargestellt, sodass ein ausgelassener Bereich geätzt werden kann, was in Fig. 2L gezeigt ist. Daraufhin erfolgt ein Entfernen der Opferschicht in Fig. 2M. Fig. 2N veranschaulicht die Beschichtung einer Metallschicht **11** auf den Trägerwafer **5.** Zudem wird die Metallschicht **11** auch als Leiterbahn **13** verwandt, um eine Übertragung von Messsignalen zu ermöglichen. Zudem sind in Fig. 2N Kontaktstellen **21** für ein anodisches Bonden mit dem MEMS-Bauteil dargestellt.

Fig. 2O zeigt schematisch einen Devicewafer **19,** der hierbei als SOI-Wafer vorliegt. Auf dem Devicewafer **19** wird eine Metallschicht beschichtet und strukturiert, was in Fig. 2P dargestellt wird. In Fig. 2Q wird an den Kontaktstellen **21** der Devicewafer mit dem Trägerwafer **5** anodisch gebondet, insbesondere über einen Presskontakt. Fig. 2R zeigt eine Bearbeitung des Devicewafers **19,** insbesondere durch ein Abdünnen und Entfernen einer Oxidschicht des SOI-Wafers. In Fig. 2S wird der Devicewafer **19** zur Bildung des MEMS-Bauteil **3,** insbesondere von beweglichen Abschnitten und einer Durchkontaktierung **15** durch ein Ätzverfahren bearbeitet. Ein Rahmen des MEMS-Bauteils **3** wird entfernt, was in Fig. 2T dargestellt ist. Fig. 2U zeigt ein Verbinden des Deckelwafers **7** durch anodisches Bonden mit dem MEMS-Bauteil **3** und ein Glasfritbonden mit dem Trägerwafer **5,** um das Halbleiterbauteil **1** herzustellen.

Vorteilhafterweise wird es hierdurch ermöglicht, Leiterbahnen 1**3** durch einen Presskontakt für einen elektrische Kontaktierung mit dem MEMS-Bauteil **3** hermetisch zu verkapseln sowie die Leiterbahnen**13** bei vergleichsweise geringen Temperaturen anzubringen. Des Weiteren wird durch die Verbindung des Trägerwafers **5** mit dem Deckelwafer **7** mittels des Glasfritbondens ein gasdichter Verschluss ermöglicht. Somit kann vorteilhafterweise weder Gas aus der Kavität in die Umgebung entweichen noch Gas aus der Umgebung in das Halbleiterbauteil **1** hineingelangen. Demzufolge kann ein in dem Halbleiterbauteil **1** eingebrachter Druck in Form eines Gases langzeitstabil beibehalten werden.

Vorteilhafterweise zeichnet sich das Verfahren durch eine erhebliche Prozesseffizienz aus, welche ein hermetisches Verkapseln des MEMS-Bauteils **1** und von Leiterbahnen **13** zur elektrischen Kontaktierung ermöglicht.

### LITERATURVERZEICHNIS

Aydemir, Akin, and Tayfun Akin. "Process development for the fabrication of a three axes capacitive MEMS accelerometer." Procedia engineering 120 (2015): 727-730.
Zhang, Yangxi, et al. "A SOI sandwich differential capacitance accelerometer with low-stress package." The 9th IEEE International Conference on Nano/Micro Engineered and Molecular Systems (NEMS). IEEE, 2014.

### BEZUGSZEICHENLISTE

- 1: Halbleiterbauteil
- 2: Kavität
- 3: MEMS-Bauteil
- 5: Trägerwafer
- 7: Deckelwafer
- 8: Vorsprung
- 9: Rahmenschicht
- 10: Stopper
- 11: Metallschicht
- 13: Leiterbahn
- 15: Umkontaktierung
- 17: bewegliche Abschnitte
- 19: Devicewafer
- 21: Kontaktstellen

## Patentansprüche

1. Halbleiterbauteil (1) umfassend ein MEMS-Bauteil (3) innerhalb eines Waferstacks umfassend mindestens einen Trägerwafer (5) und einen Deckelwafer (7), wobei das MEMS-Bauteil (3) in einer Kavität (2) zwischen dem Trägerwafer (5) und dem Deckelwafer (7) angeordnet vorliegt,
wobei das MEMS-Bauteil (3) im Bereich der Kavität anodisch gebondet mit dem Trägerwafer (5) und dem Deckelwafer (7) verbunden vorliegt und der Deckelwafer (7) mit dem Trägerwafer (5) für eine hermetisches Einkapselung des MEMS-Bauteils (3) an lateralen Abschnitten, welche die Kavität (2) umranden, mit Hilfe eines Glasfritbondens verbunden vorliegen.

2. Halbleiterbauteil (1) nach dem vorherigen Anspruch
**dadurch gekennzeichnet, dass**
jeweils eine dem MEMS-Bauteil (3) zugewandte Oberfläche des Deckelwafers (7) und des Trägerwafers (5) zumindest teilweise eine Metallschicht (11) aufweisen,
wobei bevorzugt die Metallschichten (11) als Elektroden einsetzbar sind.

3. Halbleiterbauteil (1) nach einem oder mehreren der vorherigen Ansprüche
**dadurch gekennzeichnet, dass**
das MEMS-Bauteil (3) bewegliche Abschnitte (17) aufweist,
wobei bevorzugt die beweglichen Abschnitte (17) des MEMS-Bauteils (3) horizontal und/oder vertikal auslenkbar sind.

4. Halbleiterbauteil (1) nach einem oder mehreren der vorherigen Ansprüche
**dadurch gekennzeichnet, dass**
bei einer vertikalen Auslenkung von beweglichen Abschnitten (17) des MEMS-Bauteils (3) an einer Metallschicht (11) des Deckelwafers (7) ein erstes Messsignal und an der Metallschicht (11) der Trägerwafers (5) ein zweites Messsignal sowie über das erste Messsignal und das zweite Messsignal ein differentielles Messsignal auslesbar ist.

5. Halbleiterbauteil (1) nach einem oder mehreren der vorherigen Ansprüche
**dadurch gekennzeichnet, dass**
die Metallschichten (11) mit Leiterbahnen (13) und/oder Umkontaktierungen (15) zur Übertragung von Messsignalen verbunden vorliegen,
wobei bevorzugt die Leiterbahnen (13) mit beweglichen Abschnitten des MEMS-Bauteils (3) verbunden sind.

6. Halbleiterbauteil (1) nach einem oder mehreren der vorherigen Ansprüche
**dadurch gekennzeichnet, dass**
eine dem MEMS-Bauteil (3) zugewandte Seite des Trägerwafers (5) und/oder des Deckelwafers (7) einen Vorsprung (8) aufweist, sodass ein Abstand zwischen dem MEMS-Bauteil (3) und dem Trägerwafer (5) und/oder Deckelwafer (7) regulierbar ist.

7. Halbleiterbauteil (1) nach einem oder mehreren der vorherigen Ansprüche
**dadurch gekennzeichnet, dass**
innerhalb der Kavität (2) ein Druck vorliegt innerhalb eines Bereiches zwischen 0 - 10 bar, bevorzugt zwischen 1,5 - 5 bar oder zwischen 10⁻⁶ - 0,5 bar.

8. Halbleiterbauteil (1) nach einem oder mehreren der vorherigen Ansprüche
**dadurch gekennzeichnet, dass**
das MEMS-Bauteil (3) ausgewählt ist aus einer Gruppe umfassend einen Beschleunigungssensor, einen Drehratensensor, einen Lorentzkraft-Magnetometer, einen Neigungssensor, einen Durchflusssensor und/oder einen Drucksensor.

9. System umfassend ein Halbleiterbauteil (1) nach einem oder mehreren der vorherigen Ansprüche
**dadurch gekennzeichnet, dass**
das Halbleiterbauteil (1) jeweils eine dem MEMS-Bauteil (3) zugewandte Oberfläche des Deckelwafers (7) und des Trägerwafers (5) zumindest teilweise eine Metallschicht (11) aufweisen und mit einer Recheneinheit datenverbunden ist,
wobei bevorzugt die Recheneinheit dazu konfiguriert ist, mindestens zwei Messsignale ausgehend von den Metallschichten (11) aufzunehmen und ein differentielles Messsignal zu bilden.

10. System nach dem vorherigen Anspruch
**dadurch gekennzeichnet, dass**
die Recheneinheit dazu konfiguriert ist, durch einen geschlossenen Regelkreis eine Position von beweglichen Abschnitten (17) des MEMS-Bauteils (3) einzustellen.

11. Verfahren zur Herstellung eines Halbleiterbauteils (1) umfassend ein MEMS-Bauteil (3), welches innerhalb eines Waferstacks in einer Kavität (2) zwischen einem Trägerwafer (5) und einem Deckelwafer (7) angeordnet vorliegt, umfassend die folgende Schritte:
a) Bereitstellen eines Devicewafers (19) zur Bildung des MEMS-Bauteils (3),
b) Bereitstellen eines Trägerwafers (5) und eines Deckelwafers (7) zur Bildung einer Kavität, in welchem das MEMS-Bauteil (3) angeordnet wird,
c) Anodisches Bonden des MEMS-Bauteils (3) und/oder Devicewafers (19) mit dem Trägerwafer (5) und dem Deckelwafer (7) im Bereich der Kavität (2),
d) Glasfritbonden von lateralen Abschnitten des Deckelwafers (7) und des Trägerwafers (5), welche die Kavität (2) umranden für eine hermetische Einkapselung des MEMS-Bauteils (3).

12. Verfahren nach dem vorherigen Anspruch
**dadurch gekennzeichnet, dass**
beim anodischen Bonden eine Temperatur vorliegt zwischen 300°C - 500°C und eine Spannung zwischen 50 V und 1 000 V zwischen Kontaktstellen (21) des Trägerwafer (5) und/oder des Deckelwafers (7) und dem MEMS-Bauteil (3) angelegt wird, sodass das MEMS-Bauteil (3) mit dem Trägerwafer (5) und/oder dem Deckelwafer (7) verbunden wird.

13. Verfahren nach einem oder mehreren der Ansprüche 11 - 12
**dadurch gekennzeichnet, dass**
beim Glasfritbonden ein Bondmaterial (9) auf dem Deckelwafer (7) und/oder Trägerwafer (5) angebracht wird und eine Temperatur vorliegt zwischen 400°C - 600°C, wobei eine Verbindung zwischen dem Deckelwafer (7) und dem Trägerwafer (5) über das Bondmaterial (9) durch eine Ausübung eines mechanischen Druck erfolgt, wobei bevorzugt das Bondmaterial (9) ein Material umfasst ausgewählt aus einer Gruppe umfassend Glaslote und/oder Glasfriten.

14. Verfahren nach einem oder mehreren der vorherigen Ansprüche 11 - 13
**dadurch gekennzeichnet, dass**
jeweils eine dem MEMS-Bauteil (3) zugewandte Oberfläche des Deckelwafers (7) und des Trägerwafers (5) zumindest teilweise mit einer Metallschicht (11) beschichtet wird, wobei bevorzugt Metallschichten als Elektroden fungieren.

15. Verfahren nach einem oder mehreren der vorherigen Ansprüche 11 - 14
**dadurch gekennzeichnet, dass**
der Trägerwafer (5) und/oder der Deckelwafer (7) ein Glas, bevorzugt Borsilikatglas, und/oder ein Devicewafer (19) monokristallines Silizium, Polysilizium, Siliziumdioxid, Siliziumcarbid, Siliziumgermanium, Siliziumnitrid, Nitrid, Germanium, Kohlenstoff, Galliumarsenid, Galliumnitrid, Indiumphosphid und/oder Glas umfasst.

## Claims

1. A semiconductor component (1) comprising a MEMS component (3) within a wafer stack comprising at least one carrier wafer (5) and a cover wafer (7), wherein the MEMS component (3) is arranged in a cavity (2) between the carrier wafer (5) and the cover wafer (7), wherein the MEMS component (3) is anodically bonded to the carrier wafer (5) and the cover wafer (7) in the region of the cavity, and the cover wafer (7) is connected to the carrier wafer (5) at lateral sections which border the cavity (2) by means of glass frit bonding for hermetic encapsulation of the MEMS component (3).

2. The semiconductor component (1) according to the preceding claim
**characterized in that**
each surface of the cover wafer (7) and the carrier wafer (5) facing the MEMS component (3) at least partially comprises a metal layer (11), wherein the metal layers (11) can preferably be used as electrodes.

3. The semiconductor component (1) according to any one or more of the preceding claims
**characterized in that**
the MEMS component (3) has movable sections (17),
wherein the movable sections (17) of the MEMS component (3) are preferably deflectable horizontally and/or vertically.

4. The semiconductor component (1) according to any one or more of the preceding claims
**characterized in that**
upon a vertical deflection of movable sections (17) of the MEMS component (3), a first measurement signal can be read out on a metal layer (11) of the cover wafer (7) and a second measurement signal can be read out on the metal layer (11) of the carrier wafer (5), and a differential measurement signal can be read out via the first measurement signal and the second measurement signal.

5. The semiconductor component (1) according to any one or more of the preceding claims
**characterized in that**
the metal layers (11) are connected to conductor tracks (13) and/or contact connections (15) for transmitting measurement signals,
wherein the conductor tracks (13) are preferably connected to movable sections of the MEMS component (3).

6. The semiconductor component (1) according to any one or more of the preceding claims
**characterized in that**
a side of the carrier wafer (5) and/or the cover wafer (7) facing the MEMS component (3) has a projection (8) so that a distance between the MEMS component (3) and the carrier wafer (5) and/or the cover wafer (7) can be regulated.

7. The semiconductor component (1) according to any one or more of the preceding claims
**characterized in that**
within the cavity (2) there is a pressure within a range between 0 and 10 bar, preferably between 1.5 and 5 bar or between 10⁻⁶ and 0.5 bar.

8. The semiconductor component (1) according to any one or more of the preceding claims
**characterized in that**
the MEMS component (3) is selected from a group comprising an acceleration sensor, a rotation rate sensor, a Lorentz force magnetometer, an inclination sensor, a flow sensor and/or a pressure sensor.

9. A system comprising a semiconductor component (1) according to any one or more of the preceding claims
**characterized in that**
in the semiconductor component (1) a respective surface of the cover wafer (7) and the carrier wafer (5) facing the MEMS component (3) at least partially has a metal layer (11) and is data-connected to a computing unit,
wherein the computing unit is preferably configured to receive at least two measurement signals originating from the metal layers (11) and to form a differential measurement signal.

10. The system according to the preceding claim
**characterized in that**
the computing unit is configured to adjust a position of movable sections (17) of the MEMS component (3) by means of a closed control loop.

11. A method for producing a semiconductor component (1) comprising a MEMS component (3) which is arranged within a wafer stack in a cavity (2) between a carrier wafer (5) and a cover wafer (7), comprising the following steps:
a) providing a device wafer (19) for forming the MEMS component (3),
b) providing a carrier wafer (5) and a cover wafer (7) for forming a cavity in which the MEMS component (3) is arranged,
c) anodic bonding of the MEMS component (3) and/or device wafer (19) with the carrier wafer (5) and the cover wafer (7) in the region of the cavity (2),
d) glass frit bonding of lateral sections of the cover wafer (7) and the carrier wafer (5) which border the cavity (2) for a hermetic encapsulation of the MEMS component (3).

12. The method according to the preceding claim
**characterized in that**
during anodic bonding, a temperature of between 300°C and 500°C is present and a voltage of between 50 V and 1000 V is applied between contact points (21) of the carrier wafer (5) and/or the cover wafer (7) and the MEMS component (3), so that the MEMS component (3) is connected to the carrier wafer (5) and/or the cover wafer (7).

13. The method according to any one or more of claims 11 - 12 **characterized in that**
during glass frit bonding, a bonding material (9) is applied to the cover wafer (7) and/or carrier wafer (5) and a temperature is between 400°C and 600°C, wherein a connection between the cover wafer (7) and the carrier wafer (5) is provided via the bonding material (9) by exerting mechanical pressure, wherein the bonding material (9) preferably comprises a material selected from a group comprising glass solders and/or glass frits.

14. The method according to any one or more of the preceding claims 11 - 13
**characterized in that**
a respective surface of the cover wafer (7) and of the carrier wafer (5) facing the MEMS component (3) is at least partially coated with a metal layer (11), wherein metal layers preferably function as electrodes.

15. The method according to any one or more of the preceding claims 11 - 14
**characterized in that**
the carrier wafer (5) and/or the cover wafer (7) comprises a glass, preferably borosilicate glass, and/or a device wafer (19) comprises monocrystalline silicon, polysilicon, silicon dioxide, silicon carbide, silicon germanium, silicon nitride, nitride, germanium, carbon, gallium arsenide, gallium nitride, indium phosphide and/or glass.

## Revendications

1. Composant semi-conducteur (1) comprenant un composant MEMS (3) à l'intérieur d'un empilement de plaquettes comprenant au moins une plaquette de support (5) et une plaquette de couverture (7), dans lequel le composant MEMS (3) est disposé dans une cavité (2) entre la plaquette de support (5) et la plaquette de couverture (7), dans lequel le composant MEMS (3) est lié anodiquement à la plaquette de support (5) et à la plaquette de couverture (7) dans la région de la cavité, et la plaquette de couverture (7) est reliée à la plaquette de support (5) au niveau de sections latérales qui bordent la cavité (2) au moyen d'une liaison par fritte de verre pour une encapsulation hermétique du composant MEMS (3).

2. Composant semi-conducteur (1) selon la revendication précédente
**caractérisé en ce que**
une surface respective de la plaquette de la couverture (7) et de la plaquette de support (5) faisant face au composant MEMS (3) présente au moins partiellement une couche métallique (11), dans lequel les couches métalliques (11) peuvent de préférence être utilisées comme électrodes.

3. Composant semi-conducteur (1) selon une ou plusieurs des revendications précédentes
**caractérisé en ce que**
le composant MEMS (3) présente des sections mobiles (17),
dans lequel les sections mobiles (17) du composant MEMS (3) sont de préférence déformables horizontalement et/ou verticalement.

4. Composant semi-conducteur (1) selon une ou plusieurs des revendications précédentes
**caractérisé en ce que**
lors d'une déviation verticale des sections mobiles (17) du composant MEMS (3), un premier signal de mesure peut être lu sur une couche métallique (11) de la plaquette de couverture (7) et un second signal de mesure peut être lu sur la couche métallique (11) de la plaquette de support (5), et un signal de mesure différentiel peut être lu par l'intermédiaire du premier signal de mesure et du second signal de mesure.

5. Composant semi-conducteur (1) selon une ou plusieurs des revendications précédentes
**caractérisé en ce que**
les couches métalliques (11) sont connectées à des pistes conductrices (13) et/ou à des connexions de contact (15) pour transmettre des signaux de mesure,
dans lequel les pistes conductrices (13) sont de préférence connectées à des sections mobiles du composant MEMS (3).

6. Composant semi-conducteur (1) selon une ou plusieurs des revendications précédentes
**caractérisé en ce que**
un côté de la plaquette de support (5) et/ou de la plaquette de recouvrement (7) tourné vers le composant MEMS (3) présente une saillie (8) de sorte qu'une distance entre le composant MEMS (3) et la plaquette de support (5) et/ou la plaquette de recouvrement (7) peut être réglée.

7. Composant semi-conducteur (1) selon une ou plusieurs des revendications précédentes
**caractérisé en ce que**
à l'intérieur de la cavité (2) règne une pression comprise entre 0 et 10 bar, de préférence entre 1,5 et 5 bar ou entre 10⁻⁶ et 0,5 bar.

8. Composant semi-conducteur (1) selon une ou plusieurs des revendications précédentes
**caractérisé en ce que**
le composant MEMS (3) est choisi dans un groupe comprenant un capteur d'accélération, un capteur de vitesse de rotation, un magnétomètre à force de Lorentz, un capteur d'inclinaison, un capteur de débit et/ou un capteur de pression.

9. Composant semi-conducteur (1) selon une ou plusieurs des revendications précédentes
**caractérisé en ce que**
le composant semi-conducteur (1) présente respectivement une surface de la plaquette de couverture (7) et de la plaquette de support (5) faisant face au composant MEMS (3) au moins partiellement une couche métallique (11) et est connecté en données à une unité de calcul,
dans lequel l'unité de calcul est de préférence configurée pour recevoir au moins deux signaux de mesure provenant des couches métalliques (11) et pour former un signal de mesure différentiel.

10. Système selon la revendication précédente
**caractérisé en ce que**
l'unité de calcul est configurée pour ajuster une position de sections mobiles (17) du composant MEMS (3) au moyen d'une boucle de régulation fermée.

11. Procédé de fabrication d'un composant semi-conducteur (1) comprenant un composant MEMS (3) disposé dans un empilement de plaquettes dans une cavité (2) entre une plaquette de support (5) et une plaquette de couverture (7), comprenant les étapes suivantes :
a) fourniture d'une plaquette de dispositif (19) pour former le composant MEMS (3),
b) fourniture d'une plaquette de support (5) et d'une plaquette de couverture (7) pour former une cavité, dans lequel le composant MEMS (3) est disposé,
c) liaison anodique du composant MEMS (3) et/ou de la plaquette de dispositif (19) avec la plaquette de support (5) et la plaquette de couverture (7) dans la région de la cavité (2),
d) collage par fritte de verre des sections latérales de la plaquette de couvercle (7) et de la plaquette de support (5) qui bordent la cavité (2) pour une encapsulation hermétique du composant MEMS (3).

12. Procédé selon la revendication précédente
**caractérisé en ce que**
lors de la liaison anodique, une température comprise entre 300 °C et 500 °C est présente et une tension comprise entre 50 V et 1000 V est appliquée entre les points de contact (21) de la plaquette de support (5) et/ou de la plaquette de couverture (7) et le composant MEMS (3), de sorte que le composant MEMS (3) est connecté à la plaquette de support (5) et/ou à la plaquette de couverture (7).

13. Procédé selon l'une ou plusieurs des revendications 11 à 12 **caractérisé en ce que**
lors du collage de fritte de verre, un matériau de liaison (9) est appliqué sur la plaquette de couverture (7) et/ou la plaquette de support (5) et une température est comprise entre 400 °C et 600 °C, dans lequel une connexion entre la plaquette de couverture (7) et la plaquette de support (5) est réalisée par l'intermédiaire du matériau de liaison (9) par l'exercice d'une pression mécanique, dans lequel le matériau de liaison (9) comprend de préférence un matériau choisi dans un groupe comprenant des soudures de verre et/ou des frittes de verre.

14. Procédé selon l'une ou plusieurs des revendications précédentes 11 à 13
**caractérisé en ce que**
une surface respective de la plaquette de couverture (7) et de la plaquette de support (5) tournée vers le composant MEMS (3) est au moins partiellement revêtue d'une couche métallique (11), dans lequel les couches métalliques fonctionnent de préférence comme électrodes.

15. Procédé selon l'une ou plusieurs des revendications précédentes 11 à 14
**caractérisé en ce que**
la plaquette de support (5) et/ou la plaquette de couverture (7) comprend un verre, de préférence du verre borosilicaté, et/ou une plaquette de dispositif (19) comprend du silicium monocristallin, du polysilicium, du dioxyde de silicium, du carbure de silicium, du silicium germanium, du nitrure de silicium, du nitrure de germanium, du carbone, de l'arséniure de gallium, du nitrure de gallium, du phosphure d'indium et/ou du verre.
